(19) Europäisches Patentamt
European Patent Office
Office européen des brevets

(11) **EP 4 340 255 A1**

(12) **EUROPEAN PATENT APPLICATION**
published in accordance with Art. 153(4) EPC

(43) Date of publication:
**20.03.2024 Bulletin 2024/12**

(21) Application number: **22819626.7**

(22) Date of filing: **09.06.2022**

(51) International Patent Classification (IPC):
**H04B 10/564** (2013.01)

(52) Cooperative Patent Classification (CPC):
**H04B 10/564**

(86) International application number:
**PCT/CN2022/097945**

(87) International publication number:
**WO 2022/258029 (15.12.2022 Gazette 2022/50)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **11.06.2021 CN 202110657331**

(71) Applicant: **Huawei Technologies Co., Ltd.
Shenzhen, Guangdong 518129 (CN)**

(72) Inventors:
• **LIN, Zhiyuan
Shenzhen, Guangdong 518129 (CN)**
• **CHEN, Huan
Shenzhen, Guangdong 518129 (CN)**
• **LI, Gang
Shenzhen, Guangdong 518129 (CN)**
• **WU, Xiaofan
Shenzhen, Guangdong 518129 (CN)**
• **SONG, Xiaolu
Shenzhen, Guangdong 518129 (CN)**

(74) Representative: **Körber, Martin Hans
Mitscherlich PartmbB
Patent- und Rechtsanwälte
Karlstraße 7
80333 München (DE)**

(54) **PHOTOELECTRIC ASSEMBLY, LIGHT SOURCE POOL, PHOTOELECTRIC SWITCHING DEVICE, AND CONTROL METHOD FOR PHOTOELECTRIC ASSEMBLY**

(57) This application relates to the field of optical communication, and discloses an optoelectrical assembly, a light source pool, an optoelectrical switching device, and a control method for the optoelectrical assembly, to improve efficiency of the optoelectrical assembly. The optoelectrical assembly includes a voltage conversion circuit, an optoelectrical semiconductor device, an optoelectrical detection circuit, and a controller. The voltage conversion circuit is configured to: provide a bias voltage to the optoelectrical semiconductor device, and adjust, by changing the bias voltage, an output optical power output by the optoelectrical semiconductor device. A differential resistance value Rdiff of the optoelectrical semiconductor device within a range of a target optical power satisfies $0.1\ \Omega \leq Rdiff \leq 50\ \Omega$, and the differential resistance value is a ratio of a voltage variation to a current variation corresponding to the voltage variation. The optoelectrical detection circuit is configured to: detect the output optical power output by the optoelectrical semiconductor device, and output a detection signal to the controller. The controller is configured to: determine a control signal based on the detection signal, and output the control signal to the voltage conversion circuit, where the control signal is used to adjust the bias voltage.

FIG. 2

## Description

This application claims priority to Chinese Patent Application No. 202110657331.2, filed with the China National Intellectual Property Administration on June 11, 2021 and entitled "OPTOELECTRICAL ASSEMBLY, LIGHT SOURCE POOL, OPTOELECTRICAL SWITCHING DEVICE, AND CONTROL METHOD FOR OPTOELECTRICAL ASSEMBLY", which is incorporated herein by reference in its entirety.

## TECHNICAL FIELD

This application relates to the field of optical communication, and in particular, to an optoelectrical assembly, a light source pool, an optoelectrical switching device, and a control method for the optoelectrical assembly.

## BACKGROUND

An optical power output by an optoelectrical semiconductor device may be excessively large or small. For example, the output optical power may decrease due to aging of the device or an increase of ambient temperature. To stabilize the optical power output by the optoelectrical semiconductor device within a preset range, a drive circuit may be added to the optoelectrical semiconductor device to form an optoelectrical assembly, so that the optoelectrical assembly can adjust the optical power output by the optoelectrical semiconductor device, to complete an automatic power control (automatic power control, APC) function.

However, a current optoelectrical assembly adjusts, by using an adjustable current source, an optical power output by an optoelectrical semiconductor device, resulting in low efficiency.

## SUMMARY

Embodiments of this application provide an optoelectrical assembly, a light source pool, an optoelectrical switching device, and a control method for the optoelectrical assembly, to improve efficiency of the optoelectrical assembly.

To achieve the foregoing objectives, the following technical solutions are used in embodiments of this application.

According to a first aspect, an optoelectrical assembly is provided, including a voltage conversion circuit, an optoelectrical semiconductor device, an optoelectrical detection circuit, and a controller. The voltage conversion circuit is configured to: provide a bias voltage to the optoelectrical semiconductor device, and adjust, by changing the bias voltage, an output optical power output by the optoelectrical semiconductor device, where a differential resistance value Rdiff of the optoelectrical semiconductor device within a range of a target optical power satisfies $0.1 \ \Omega \leq Rdiff \leq 50 \ \Omega$, and the differential resistance value is a ratio of a voltage variation to a current variation corresponding to the voltage variation. The optoelectrical detection circuit is configured to: detect the output optical power output by the optoelectrical semiconductor device, and output a detection signal to the controller. The controller is configured to: determine a control signal based on the detection signal, and output the control signal to the voltage conversion circuit, where the control signal is used to adjust the bias voltage. The target optical power is usually determined based on an optical power budget range of an optical link of a system in which the optoelectrical assembly, a light source pool, or an optoelectrical switching device is located, to ensure that the system can be in a normal operating state in which a bit error rate is less than a specific index. In this application, the optoelectrical assembly includes a load link and a feedback link. The load link serves as a load of the voltage conversion circuit and includes the voltage conversion circuit and the optoelectrical semiconductor device. The feedback link includes the optoelectrical detection circuit and the controller. The controller does not need to receive current sampling information of the load link. The bias voltage can be adjusted based on the output signal of the optoelectrical detection circuit.

In the optoelectrical assembly provided in this embodiment of this application, the voltage conversion circuit provides the bias voltage to the optoelectrical semiconductor device, to adjust the output optical power output by the optoelectrical semiconductor device. The optoelectrical detection circuit receives the light output by the optoelectrical semiconductor device, detects the output optical power output by the optoelectrical semiconductor device, and outputs the detection signal to the controller. The controller may determine, based on the detection signal, the control signal used to adjust the bias voltage, and send the control signal to the voltage conversion circuit. Another detection circuit does not need to be coupled between the voltage conversion circuit and the optoelectrical semiconductor device, an additional power output by the voltage conversion circuit is not consumed, and most of the power output by the voltage conversion circuit is converted into the output optical power output by the optoelectrical semiconductor device. Therefore, this can improve efficiency of the optoelectrical assembly.

The differential resistance value Rdiff of the optoelectrical semiconductor device within the range of the target optical power mainly meets a requirement of $0.1 \ \Omega \leq Rdiff \leq 50 \ \Omega$ due to the following reasons:

When the differential resistance value Rdiff of the optoelectrical semiconductor device within the range of the target optical power is excessively large, the optoelectrical semiconductor device needs to input a large bias voltage variation to enable an equivalent current of the optoelectrical semiconductor device to generate a small current variation. In other words, when the bias voltage input to the optoelectrical semiconductor device has a large variation, a variation of the equivalent current flowing through the optoelectrical semiconductor device is small, and correspondingly, a carrier concentration variation is small and is insufficient to effectively change the output optical power output by the optoelectrical semiconductor device. For example, it is assumed that the differential resistance value Rdiff=100 Q. A voltage variation of 100 mV is required to generate a current variation of 1 mA, which usually corresponds to a state before a turn-on threshold of the optoelectrical semiconductor device is reached, and cannot be used for normal operation of an automatic power control (automatic power control, APC) loop. Even if the optoelectrical semiconductor device is in a good lasing state above the turn-on threshold at this time, a voltage variation of 1 V is required to realize a current variation of 10 mA for such an optoelectrical semiconductor device. In a practical application process, it is difficult to apply due to limitations of a voltage output capability and voltage conversion efficiency of the voltage conversion circuit.

When the differential resistance value Rdiff of the optoelectrical semiconductor device within the range of the target optical power is excessively small, a small bias voltage variation input to the optoelectrical semiconductor device may cause a current of the optoelectrical semiconductor device to generate a large current variation, and correspondingly, a carrier concentration variation is extremely large. The output optical power output by the optoelectrical semiconductor device changes greatly, and may fall within a range within which the optical power is excessively large or excessively small, or may fall within a roll-off operating range of the optoelectrical semiconductor device, (that is, the output optical power decreases with an increase of an injection current). Therefore, it is difficult to apply to APC. For example, it is assumed that the differential resistance value of the optoelectrical semiconductor device within the range of the target optical power is 0.01 Ω. When an input voltage variation is 1 mV, a current variation of a current flowing through the optoelectrical semiconductor device is 100 mA. This is unacceptable for feedback adjustment of the APC loop.

The optoelectrical semiconductor device in embodiments of this application is a light emitting device made of a semiconductor material, and includes, for example, a light source (for example, a laser diode (laser diode, LD), a laser, or a lidar) or a semiconductor optical amplifier (semiconductor optical amplifier, SOA).

A bias adjustment circuit in this embodiment of this application is a circuit, for example, an adjustable voltage source or an adjustable current source, that is configured to adjust a bias voltage or a bias current of the optoelectrical semiconductor device.

In this embodiment of this application, the voltage conversion circuit replaces the adjustable current source to provide the bias voltage to the optoelectrical semiconductor device, and collects only an output optical power output by the optoelectrical assembly as feedback instead of collecting a current of the load link, to control a bias voltage output by the voltage conversion circuit. Therefore, linear control is implemented, and control logic is simple. Compared with the conventional technology in which the adjustable current source provides a drive current to the optoelectrical semiconductor device, in this technology, the voltage conversion circuit provides the bias voltage to the optoelectrical semiconductor device. This can improve conversion efficiency. A reason is that the solution provided in this embodiment of this application may be applied to an application scenario with a high power and a high drive current. For example, the optoelectrical assembly may be used as an externally modulated light source (namely, a light source separated from an optical modulator), or may be used as an optical amplifier. The optoelectrical assembly, the light source pool, or the optoelectrical switching device needs to output light to a plurality of silicon photonic links, has a high output optical power of up to about 100 mW, and requires high carrier density, that is, a high drive current needs to be injected. However, the adjustable current source provides a drive current to the optoelectrical semiconductor device. As a result, a larger drive current indicates a larger additional voltage drop generated by a current sampling circuit, and lower conversion efficiency of the entire optoelectrical assembly. The voltage conversion circuit (for example, a direct current-direct current (direct current-direct current, DC-DC) conversion circuit) provides a bias voltage to the optoelectrical semiconductor device. In essence, voltage conversion is implemented through charging and discharging of a high-frequency switch, an inductor, a capacitor, a transformer, or the like. Therefore, no large additional voltage drop is generated, and conversion efficiency can reach 90% or even 93%. In addition, there is no operational amplifier required in the optoelectrical assembly based on the adjustable current source. Therefore, this can reduce costs, improve integration, and facilitate miniaturization of the optoelectrical assembly.

In a possible implementation, the optoelectrical assembly may be an externally modulated light source (namely, a light source separated from an optical modulator) or an optical amplifier. The optoelectrical assembly can be used as a device that requires a high power and a high drive current, such as an externally modulated light source or an optical amplifier.

In a possible implementation, the optoelectrical semiconductor device is a light source, and a resistance value of the light source is less than or equal to 60 Q within the range of the target optical power.

In a possible implementation, the optoelectrical semiconductor device is an optical amplifier, and a resistance value of the optical amplifier is less than or equal to 60 Q within the range of the target optical power.

When a resistance value of the optoelectrical semiconductor device is small, it indicates that the optoelectrical semiconductor device is well turned on and enters a good lasing state. In this case, a current-voltage relationship curve of the optoelectrical semiconductor device changes smoothly and has an obvious linear characteristic, the differential resistance value of the optoelectrical semiconductor device is also moderate, and a change of the bias voltage of the optoelectrical semiconductor device may cause a linear change of a corresponding current of the optoelectrical semiconductor device, and then cause a linear change of carrier concentration of the optoelectrical semiconductor device. This can linearly and effectively change the output optical power output by the optoelectrical semiconductor device. On the contrary, when a resistance value of the optoelectrical semiconductor device is large, it indicates that the optoelectrical semiconductor device is in a state near the threshold. In this case, a change of the bias voltage of the optoelectrical semiconductor device may cause a non-linear change of a corresponding current of the optoelectrical semiconductor device, and then cause a non-linear change of carrier concentration of the optoelectrical semiconductor device. It is difficult to linearly and effectively change the output optical power output by the optoelectrical semiconductor device.

In a possible implementation, the voltage conversion circuit is a unique bias adjustment circuit of the optoelectrical semiconductor device. To be specific, the output optical power of the optoelectrical semiconductor device is controlled by only a bias voltage output by the voltage conversion circuit, and the adjustable current source or the like is not required to provide a drive current.

In a possible implementation, a bit width of a digital signal processed by the controller is greater than or equal to 6 bits. The controller may be a micro-control unit (micro-control unit, MCU), a field-programmable gate array (field-programmable gate array, FPGA), or the like.

In this application, the bit width of the digital signal processed by the controller is required to be at least 6 bits, and a voltage variation corresponding to a minimum weight bit can meet a requirement for fine adjustment of the bias voltage output by the voltage conversion circuit, to implement accurate control on the bias voltage output by the voltage conversion circuit. If the digital signal processed by the controller has only 4 bits, for example, an internal reference voltage 2.5 V of the controller corresponds to a maximum value of a four-bit binary number, a voltage variation corresponding to a minimum weight bit of a control signal Z output by the controller is $2.5 \, V/2^4 \approx 156$ mV. This voltage adjustment precision is unacceptable. If the bit width of the digital signal processed by the controller is 6 bits, for example, an internal reference voltage 2.5 V of the controller corresponds to a maximum value of a 6-bit binary number, a voltage variation corresponding to a minimum weight bit of a control signal Z output by the controller is $2.5 \, V/2^6 \approx 39$ mV. Even if precision of the bias voltage output by the voltage conversion circuit is the same as the voltage variation 39 mV corresponding to the minimum weight bit of the control signal Z, when the differential resistance value Rdiff of the optoelectrical semiconductor device within the range of the target optical power is 10 Q and a bias voltage variation output by the voltage conversion circuit is 39 mV, the current variation of the current flowing through the optoelectrical semiconductor device is 3.9 mA. This may be considered as a case in which an equivalent adjustment current step is large in APC loop control, but it is also acceptable. Further, if the bit width of the digital signal processed by the controller is 8 bits, for example, an internal reference voltage 2.5 V of the controller corresponds to a maximum value of an 8-bit binary number, a voltage variation corresponding to a minimum weight bit of a control signal Z output by the controller is $2.5 \, V/2^8 \approx 9.8$ mV. Even if precision of the bias voltage output by the voltage conversion circuit is the same as the voltage variation 9.8 mV corresponding to the minimum weight bit of the control signal Z, when the differential resistance value Rdiff of the optoelectrical semiconductor device within the range of the target optical power is 10 Q and a bias voltage variation output by the voltage conversion circuit is 9.8 mV, the current variation of the current flowing through the optoelectrical semiconductor device is 0.98 mA. This may be considered as a case in which an equivalent adjustment current step is small in APC loop control, and it is acceptable.

In a possible implementation, the controller is further configured to enable or disable the voltage conversion circuit.

When the controller is initialized, the voltage conversion circuit is first disabled, and then the voltage conversion circuit is enabled after the controller outputs the control signal to the voltage conversion circuit. Alternatively, in a controller initialization process, the voltage conversion circuit may be disabled based on a fixed high/low level as an input or through another logic gate circuit. Alternatively, in a controller initialization process, the voltage conversion circuit may be enabled through a soft-start circuit, to turn on the optoelectrical semiconductor device. In this way, the optoelectrical semiconductor device can be prevented from being burnt due to an unstable control signal in the initialization process and an excessively large bias voltage output by the voltage conversion circuit. Otherwise, if the voltage conversion circuit is in an enabled state before the controller outputs the control signal, the bias voltage output by the voltage conversion circuit is not controlled, and therefore may be excessively large. As a result, the optoelectrical semiconductor device in the load link is burnt. In addition, these methods can be combined.

In a possible implementation, the controller is configured to: obtain load link information, and determine the control signal based on the load link information and the detection signal, where the load link information includes a value of a bias voltage.

If the load link information indicates an actual value of the bias voltage, a deviation between a theoretical value of the bias voltage and the actual value caused by a device parameter deviation and fluctuation in a feedback network can be eliminated, and a more accurate input is provided for the controller to obtain the control signal Z. For example, the controller may calculate the control signal Z according to a formula Z=A*X+B*Y+C, or obtain the control signal Z through table lookup, where A is an adjustment rule corresponding to load link information X, B is an adjustment rule corresponding to a backlight sampling voltage Y, C is a fitting constant, and values of A, B, and C may be obtained by searching for a pre-calibrated or pre-fitted table in the controller, or may be obtained through real-time calculation. Further, A, B, and C in the pre-calibrated or pre-fitted table in the controller may be corrected based on an actual accurate input.

In a possible implementation, the optoelectrical assembly further includes a temperature control drive circuit and a temperature control circuit. The temperature control drive circuit is configured to supply power to the temperature control circuit, and the temperature control circuit is configured to perform temperature control on the optoelectrical semiconductor device.

Temperature control may include, for example, cooling or heating, so that the optoelectrical semiconductor device operates at a preset operating temperature, to increase the output optical power or prolong service life of the optoelectrical semiconductor device. For example, the temperature control circuit may be a thermoelectric cooler (thermoelectric cooler, TEC).

In a possible implementation, a power supply voltage input by the temperature control drive circuit ranges from 2 V to 18 V

A value of the power supply voltage may be optimized and set based on a voltage, a current, a cooling capacity, a heating capacity, cooling power consumption, heating power consumption, and the like of the temperature control drive circuit and the temperature control circuit, to improve power supply energy efficiency of the temperature control circuit. For example, the power supply voltage may be 3.3 V, 5 V, 12 V, or the like, and deviation precision of the power supply voltage may be less than or equal to 20%. Further, the deviation precision of the power supply voltage may be less than or equal to 10%. Still further, the deviation precision of the power supply voltage may be less than or equal to 5%.

In a possible implementation, a power supply voltage input by the voltage conversion voltage ranges from 1.8 V to 18 V

A value of the power supply voltage may be optimized and set based on an input-output voltage change efficiency curve of the voltage conversion circuit, to improve voltage conversion efficiency of the voltage conversion circuit as much as possible. For example, the power supply voltage may be 3.3 V, 5 V, 12 V, or the like, and deviation precision of the power supply voltage may be less than or equal to 20%. Further, the deviation precision of the power supply voltage may be less than or equal to 10%. Still further, the deviation precision of the power supply voltage may be less than or equal to 5%.

In a possible implementation, a power supply voltage input by the controller ranges from 1.5 V to 6 V A value of the power supply voltage may be optimized and set based on a voltage, a current, and power consumption of devices such as a controller, an analog-to-digital converter, and a digital-to-analog converter, to ensure normal operation of the device and improve system stability. For example, the power supply voltage may range from 1.8 V to 3.6 V Further, the power supply voltage may be 3.3 V, and deviation precision of the power supply voltage may be less than or equal to 20%. Further, the deviation precision of the power supply voltage may be less than or equal to 10%. Still further, the deviation precision of the power supply voltage may be less than or equal to 5%.

The power supply voltage connected to the voltage conversion circuit, the temperature control drive circuit, and the controller is determined based on a load characteristic of a coupled device. This can improve power supply energy efficiency, reduce power consumption, and improve system stability.

In a possible implementation, if the detection signal is less than a first threshold, the control signal indicates to increase the bias voltage. The detection signal corresponds to the output optical power output by the optoelectrical semiconductor device. That the detection signal is less than the first threshold indicates an excessively small output optical power output by the optoelectrical semiconductor device. Therefore, the control signal indicates the voltage conversion circuit to increase the bias voltage, to increase the output optical power output by the optoelectrical semiconductor device.

In a possible implementation, if the detection signal is greater than a second threshold, the control signal indicates to decrease the bias voltage. The detection signal corresponds to the output optical power output by the optoelectrical semiconductor device. That the detection signal is greater than the second threshold indicates an excessively large output optical power output by the optoelectrical semiconductor device. Therefore, the control signal indicates the voltage conversion circuit to decrease the bias voltage, to increase the output optical power output by the optoelectrical semiconductor device.

In a possible implementation, the voltage conversion circuit includes a first voltage conversion circuit and a second voltage conversion circuit. The optoelectrical semiconductor device includes a first optoelectrical semiconductor device and a second optoelectrical semiconductor device. The optoelectrical detection circuit includes a first optoelectrical detection circuit and a second optoelectrical detection circuit. The first optoelectrical detection circuit is configured to:

detect an output optical power output by the first optoelectrical semiconductor device, and output a first detection signal to the controller. The second optoelectrical detection circuit is configured to: detect an output optical power output by the second optoelectrical semiconductor device, and output a second detection signal to the controller. The controller is configured to: determine a first control signal based on the first detection signal, and send the first control signal to the first voltage conversion circuit, where the first control signal is used to adjust a bias voltage provided to the first optoelectrical semiconductor device; and determine a second control signal based on the second detection signal, and send the second control signal to the second voltage conversion circuit, where the second control signal is used to adjust a bias voltage provided to the second optoelectrical semiconductor device.

The optoelectrical assembly provided in this embodiment of this application is not limited to supporting two optoelectrical semiconductor devices to output light, and may further include more optoelectrical semiconductor devices, to output a plurality of paths of light.

In a possible implementation, the optoelectrical assembly further includes a digital-to-analog converter. The controller is configured to send the first control signal and the second control signal to the digital-to-analog converter in a serial manner. The digital-to-analog converter is configured to: perform digital-to-analog conversion on the first control signal and output a signal obtained through digital-to-analog conversion to the first voltage conversion circuit; and perform digital-to-analog conversion on the second control signal and output a signal obtained through digital-to-analog conversion to the second voltage conversion circuit.

This implementation improves design flexibility of the optoelectrical assembly, and can further reduce a resource requirement for a digital-to-analog conversion interface of the controller, reduce a quantity of digital-to-analog converters, reduce costs, improve integration, and facilitate miniaturization of the optoelectrical assembly. For example, when the digital-to-analog converter converts two digital signals into one analog signal, 50% of digital-to-analog converters can be reduced. When the digital-to-analog converter can convert more digital signals into one analog signal, more digital-to-analog converters can be reduced.

In a possible implementation, a bit width of the digital-to-analog converter is greater than or equal to 6 bits. For example, the bit width of the digital-to-analog converter is consistent with the bit width of the digital signal processed by the controller.

In a possible implementation, the optoelectrical semiconductor device includes a first optoelectrical semiconductor device and a second optoelectrical semiconductor device. The optoelectrical detection circuit includes a first optoelectrical detection circuit and a second optoelectrical detection circuit. The first optoelectrical detection circuit is configured to: detect an output optical power output by the first optoelectrical semiconductor device, and output a first detection signal to the controller. The second optoelectrical detection circuit is configured to: detect an output optical power output by the second optoelectrical semiconductor device, and output a second detection signal to the controller. The controller is configured to: determine the control signal based on the first detection signal and the second detection signal, and send the control signal to the voltage conversion circuit, where the control signal is used to adjust a bias voltage provided to the first optoelectrical semiconductor device and a bias voltage provided to the second optoelectrical semiconductor device.

In a possible implementation, if the first detection signal is less than the second detection signal, and the first detection signal is less than the first threshold, the control signal indicates to increase the bias voltage.

In a possible implementation, if the first detection signal is less than the second detection signal, and the second detection signal is greater than the second threshold, the control signal indicates to decrease the bias voltage.

In a possible implementation, the optoelectrical assembly further includes an analog-to-digital converter. The analog-to-digital converter is configured to: perform analog-to-digital conversion on the first detection signal, perform analog-to-digital conversion on the second detection signal, and output the first detection signal and the first detection signal that are obtained through analog-to-digital conversion to the controller in a serial manner.

This implementation improves design flexibility of the optoelectrical assembly, and can further reduce a resource requirement for an analog-to-digital conversion interface, reduce a quantity of analog-to-digital converters, reduce costs, improve integration, and facilitate miniaturization of the optoelectrical assembly. For example, when the analog-to-digital converter converts two analog signals into one digital signal, 50% of analog-to-digital converters can be reduced. When the analog-to-digital converter can convert more analog signals into one digital signal, more analog-to-digital converters can be reduced.

In a possible implementation, a bit width of the analog-to-digital converter is greater than or equal to 6 bits. For example, the bit width of the analog-to-digital converter is consistent with the bit width of the digital signal processed by the controller.

In a possible implementation, the optoelectrical assembly further includes a feedback network. The feedback network is configured to increase or decrease a voltage range of the control signal.

The feedback network can further improve precision of the control signal, and can further improve precision of the bias voltage output by the voltage conversion circuit, that is, equivalently improve resolution of the analog-to-digital conversion interface in the DAC or the controller.

In a possible implementation, the feedback network includes a first resistor, a second resistor, and a third resistor. A second end of the first resistor is grounded. A first end of the first resistor, a second end of the second resistor, and a first end of the third resistor are coupled to a feedback end of the voltage conversion circuit. A first end of the second resistor is coupled to an output end of the voltage conversion circuit. A second end of the third resistor is coupled to an output end of the controller. The output end of the controller is configured to output the control signal. The feedback end of the voltage conversion circuit is configured to input the control signal whose voltage range is increased or decreased.

The feedback network based on a resistor voltage divider network implements a linear increase or decrease of the control signal based on a feedback control signal, to meet a requirement for a range of a signal input by the voltage conversion circuit, and improve precision of the control signal. In addition, the feedback network is simple in design and compact in structure. This facilitates miniaturization of the entire optoelectrical assembly.

In a possible implementation, the voltage conversion circuit is a direct current-direct current conversion circuit.

In this application, voltage conversion is implemented through charging and discharging of a high-frequency switch, an inductor, a capacitor, a transformer, or the like in the direct current-direct current conversion circuit. Therefore, no large additional voltage drop is generated, and conversion efficiency can reach 90% or even 93%.

According to a second aspect, a light source pool is provided, including at least one optoelectrical assembly in any one of the first aspect and the implementations of the first aspect.

The solution provided in this embodiment of this application may be applied to an application scenario with a high power and a high drive current. The light source pool needs to output light to a plurality of silicon photonic links, has a high output optical power of up to about 100 mW, and requires high carrier density, that is, a high drive current needs to be injected. For a 10 W light source pool, power consumption of nearly 3 W can be reduced by using the optoelectrical assembly in this application. This can greatly improve a thermal design, reliability, and external power supply pressure of a product, can greatly prolong service life of the product, can miniaturize the product, and further improve comprehensive competitiveness of the product.

According to a third aspect, an optoelectrical switching device is provided, including at least one of the optoelectrical assembly in any one of the first aspect or the implementations of the first aspect or the light source pool in the second aspect, an optical modulator, and a switching chip. The optoelectrical assembly or the light source pool is configured to output light. The switching chip is configured to control the optical modulator to modulate the light output by the optoelectrical assembly or the light source pool.

The solution provided in this embodiment of this application may be applied to an application scenario with a high power and a high drive current. The optoelectrical switching device requires at least one of the optoelectrical assembly or the light source pool to output light to a plurality of silicon photonic links of the optical modulator in the optoelectrical switching device, has a high output optical power of up to about 100 mW, and requires high carrier density, that is, a high drive current needs to be injected. This can implement miniaturization of the optoelectrical switching device, can improve drive efficiency, and reduce power consumption of the entire optoelectrical switching device.

In a possible implementation, the optoelectrical switching device further includes a first controller, and the first controller may determine a board control signal based on whether a value of an optical power output by the optoelectrical switching device meets a requirement, and output the board control signal to the controller of the optoelectrical assembly to request adjustment of the output optical power output by the optoelectrical assembly or the light source pool, or output the board control signal to a controller of the light source pool to request adjustment of the output optical power output by the light source pool, to increase or decrease the optical power output by the optoelectrical switching device, or decrease the output optical power to zero.

According to a fourth aspect, a control method for an optoelectrical assembly is provided. The method may be applied to the optoelectrical assembly in any one of the first aspect and the implementations of the first aspect. The method includes: receiving a detection signal from an optoelectrical detection circuit in the optoelectrical assembly, where the detection signal indicates an output optical power output by an optoelectrical semiconductor device in the optoelectrical assembly; and determining a control signal based on the detection signal, and sending the control signal to a voltage conversion circuit in the optoelectrical assembly, where the control signal is used to adjust a bias voltage.

In a possible implementation, the method further includes: disabling the voltage conversion circuit, and outputting a preset control signal to the voltage conversion circuit, to enable the voltage conversion circuit.

In a possible implementation, if the detection signal is less than a first threshold, the control signal indicates to increase the bias voltage.

In a possible implementation, if the detection signal is greater than a second threshold, the control signal indicates to decrease the bias voltage.

In a possible implementation, the method further includes: obtaining load link information, where the load link information includes a value of the bias voltage. The determining a control signal based on the detection signal includes: determining the control signal based on the load link information and the detection signal.

In a possible implementation, the method further includes: sending a first control signal and a second control signal to a digital-to-analog converter in the optoelectrical assembly in a serial manner, where the first control signal is used to adjust a bias voltage provided to a first optoelectrical semiconductor device, and the second control signal is used to adjust a bias voltage provided to a second optoelectrical semiconductor device.

In a possible implementation, the method further includes: determining the control signal based on a first detection signal and a second detection signal, and sending the control signal to the voltage conversion circuit, where the control signal is used to adjust a bias voltage provided to a first optoelectrical semiconductor device and a bias voltage provided to a second optoelectrical semiconductor device, the first detection signal indicates an output optical power output by the first optoelectrical semiconductor device, and the second detection signal indicates an output optical power output by the second optoelectrical semiconductor device.

In a possible implementation, if the first detection signal is less than the second detection signal, and the first detection signal is less than the first threshold, the control signal indicates to increase the bias voltage.

In a possible implementation, if the first detection signal is less than the second detection signal, and the second detection signal is greater than the second threshold, the control signal indicates to decrease the bias voltage.

For technical effect of the second aspect to the fourth aspect, refer to the technical effect of any one of the first aspect and the implementations of the first aspect.

## BRIEF DESCRIPTION OF DRAWINGS

FIG. 1 is a schematic diagram of a structure of an optoelectrical switching device according to an embodiment of this application;

FIG. 2 is a schematic diagram 1 of a structure of an optoelectrical assembly according to an embodiment of this application;

FIG. 3 is a schematic diagram 2 of a structure of an optoelectrical assembly according to an embodiment of this application;

FIG. 4 is a schematic diagram 3 of a structure of an optoelectrical assembly according to an embodiment of this application;

FIG. 5 is a schematic diagram 4 of a structure of an optoelectrical assembly according to an embodiment of this application;

FIG. 6 is a schematic diagram 5 of a structure of an optoelectrical assembly according to an embodiment of this application;

FIG. 7A, FIG. 7B, FIG. 7C, FIG. 7D, FIG. 7E, and FIG. 7F each area schematic diagram of a coupling manner between a power supply, a voltage conversion circuit, and an optoelectrical semiconductor device according to an embodiment of this application;

FIG. 8A, FIG. 8B, FIG. 8C, and FIG. 8D each are a schematic diagram of a coupling manner between an ADC and a controller according to an embodiment of this application;

FIG. 9A, FIG. 9B, FIG. 9C, and FIG. 9D each are a schematic diagram of a coupling manner between a DAC and a controller according to an embodiment of this application;

FIG. 10 is a schematic diagram 6 of a structure of an optoelectrical assembly according to an embodiment of this application;

FIG. 11 is a schematic diagram 7 of a structure of an optoelectrical assembly according to an embodiment of this application;

FIG. 12 is a schematic diagram 8 of a structure of an optoelectrical assembly according to an embodiment of this application;

FIG. 13 is a schematic diagram 9 of a structure of an optoelectrical assembly according to an embodiment of this application;

FIG. 14 is a schematic diagram 10 of a structure of an optoelectrical assembly according to an embodiment of this application;

FIG. 15 is a schematic diagram 11 of a structure of an optoelectrical assembly according to an embodiment of this application;

FIG. 16 is a schematic diagram 12 of a structure of an optoelectrical assembly according to an embodiment of this application;

FIG. 17 is a schematic diagram of a coupling manner between a power supply, a voltage conversion circuit, a temperature control drive circuit, and a controller according to an embodiment of this application;

FIG. 18 is a schematic diagram 13 of a structure of an optoelectrical assembly according to an embodiment of this application;

FIG. 19 is a schematic flowchart of a control method for an optoelectrical assembly according to an embodiment of this application; and
FIG. 20 is a schematic flowchart of another control method for an optoelectrical assembly according to an embodiment of this application.

## DESCRIPTION OF EMBODIMENTS

With rapid development of technologies such as cloud computing, big data, 5th generation (5th generation, 5G) communication, and autonomous driving, higher requirements, such as miniaturization, a high bandwidth, and low power consumption, are also proposed for an optoelectrical module or an optoelectrical component used in an optical communication network However, the high bandwidth requires an increasing optical power of an optoelectrical semiconductor device used in the optoelectrical module or the optoelectrical component, an increasing drive current, and increasing power consumption. For example, Table 1 shows drive currents and power consumption of the optoelectrical semiconductor device in different application scenarios. This brings adverse impact on a design with miniaturization and low power consumption, and further brings unprecedented challenges to a design of a drive circuit of the optoelectrical semiconductor device.

**Table 1**

| Scenario | Optical communication | | Autonomous driving |
|---|---|---|---|
| Optical module or optical component | Light source pool including a laser | Optical amplifier | Lidar |
| Current of each laser diode | About 400 mA | About 1 A | About 2.5 A or higher |
| Power consumption | About 12 W | About 4 W | About 20 W |

The optoelectrical semiconductor device in embodiments of this application is a light emitting device made of a semiconductor material, and includes, for example, a laser diode (laser diode, LD), a laser, a semiconductor optical amplifier (semiconductor optical amplifier, SOA), a lidar, or another device.

An existing optoelectrical assembly adjusts, by using a drive current (which may also be referred to as a bias current) output by an adjustable current source, an optical power output by the optoelectrical semiconductor device. This solution has the following disadvantages.

1. Driving efficiency is low. Because the optoelectrical assembly needs to transform an input voltage and then output a transformed voltage to the adjustable current source, conversion efficiency is reduced. The drive current output by the adjustable current source needs to be detected by a current sampling circuit. This generates an unnecessary voltage drop and further reduces conversion efficiency. Therefore, the conversion efficiency of the entire optoelectrical assembly is about 66.5%.
2. There are a plurality of feedback loops, a plurality of input parameters for adjustment, and complex rules. When adjusting the bias current output by the adjustable current source, the optoelectrical assembly depends on the plurality of input parameters, including, for example, a current value of the drive current and the optical power output by the optoelectrical semiconductor device. As a result, simple linear control cannot be implemented, and the control rule is complex.
3. A system needs an additional current sampling circuit, resulting in high hardware costs. Because the current sampling circuit needs to be added to detect the drive current, sometimes an operational amplifier needs to be added to amplify a sampling value of the drive current, to improve resolution of detecting the drive current. This is unfavorable to system miniaturization and cost reduction.
4. To precisely control the drive current, a specific quantity of bits for digital-to-analog or analog-to-digital conversion in the optoelectrical assembly needs to reached, so that a voltage or current variation corresponding to a minimum weight bit for digital-to-analog or analog-to-digital conversion meets a requirement for precise control. Usually, about 10 bits need to be reached.
5. A power-on sequence of different components in the system and protection of the optoelectrical semiconductor device are not considered. As a result, the optoelectrical semiconductor device is easily burnt due to an excessively large bias voltage.

Therefore, embodiments of this application provide an optoelectrical assembly, a light source pool including the optoelectrical assembly, an optoelectrical switching device including at least one of the optoelectrical assembly or the light source pool, and a control method for the optoelectrical assembly. A voltage conversion circuit in the optoelectrical assembly provides a bias voltage to an optoelectrical semiconductor device in the optoelectrical assembly, to adjust an output optical power output by the optoelectrical semiconductor device. An optoelectrical detection circuit in the optoelectrical assembly receives light output by the optoelectrical semiconductor device, detects the output optical power output by the optoelectrical semiconductor device, and outputs a detection signal to a controller in the optoelectrical assembly. The controller may determine, based on the detection signal, a control signal used to adjust the bias voltage, and send the control signal to the voltage conversion circuit. A differential resistance value Rdiff of the optoelectrical semiconductor device within a range of a target optical power satisfies 0.1 Ω≤Rdiff≤50 Ω, and the differential resistance value is a ratio of a voltage variation to a current variation corresponding to the voltage variation. For example, the differential resistance value Rdiff of the optoelectrical semiconductor device within the range of the target optical power satisfies 0.1 Ω≤Rdiff≤20 Ω. For another example, the differential resistance value Rdiff of the optoelectrical semiconductor device within the range of the target optical power satisfies 1 Ω≤Rdiff≤15 Ω, satisfies 2 Ω≤Rdiff≤10 Ω, satisfies 2 Q≤Rdiff≤8 Ω, or satisfies 2 Ω≤Rdiff≤6 Ω.

The voltage conversion circuit replaces the adjustable current source to provide the bias voltage to the optoelectrical semiconductor device, and collects only an output optical power output by the optoelectrical assembly as feedback instead of collecting a current of a load link, to control a bias voltage output by the voltage conversion circuit. Therefore, linear control is implemented, and control logic is simple. In addition, because the current sampling circuit for collecting the current of the load link is canceled, there is only the optoelectrical semiconductor device in the load link, and there is no voltage drop generated by the current sampling circuit, conversion efficiency of a power output by the voltage conversion circuit can reach 90% or even 93%. Compared with the solution in which the adjustable current source provides the drive current, this solution in this application improves the conversion efficiency by (90-66.5)/66.5=35%. There is no operational amplifier. Therefore, this can reduce costs, improve integration, and facilitate miniaturization of the optoelectrical assembly.

The optoelectrical assembly, the light source pool, the optoelectrical switching device, and the control method for the optoelectrical assembly provided in embodiments of this application may be applied to an application scenario that requires a large drive current, such as a 10 G passive optical network (10 G passive optical network, XGPON), a 50 G passive optical network (50 G passive optical network, 50 G PON), an SOA, or an autonomous driving lidar.

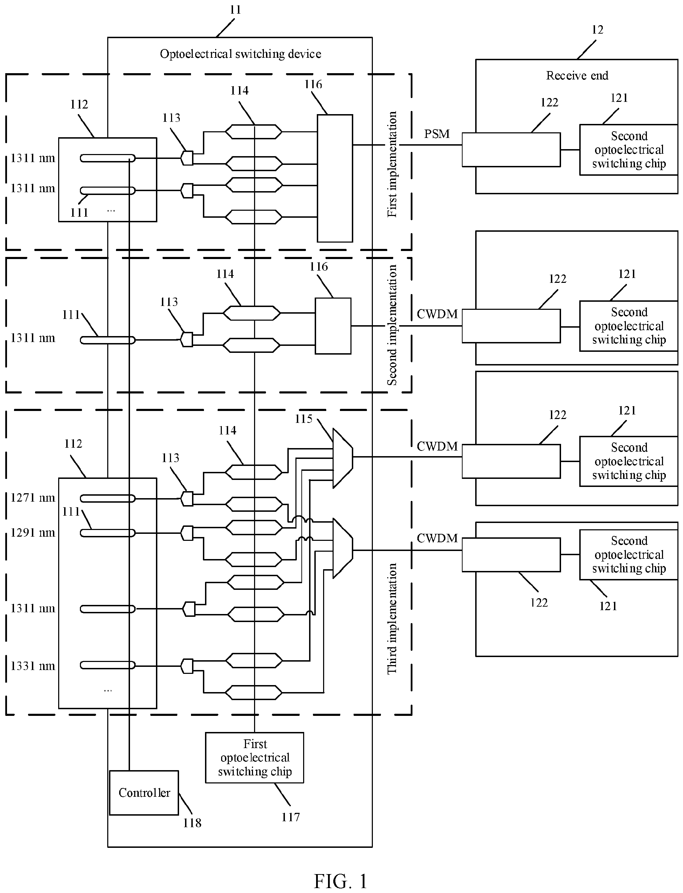

As shown in FIG. 1, an optoelectrical switching device 11 provided in this embodiment of this application includes at least one of an optoelectrical assembly 111 or a light source pool 112, a plurality of optical power splitter 113, a plurality of optical modulators 114, a plurality of wavelength division multiplexers 115, a multi-channel optical fiber array 116, a first optical-electrical switching chip 117, and a controller 118.

It should be noted that, in a first implementation, the optoelectrical switching device 11 may include the light source pool 112, the optical power splitter 113, the optical modulator 114, and the multi-channel optical fiber array 116. Alternatively, in a second implementation, the optoelectrical switching device 11 may include the optoelectrical assembly 111, the optical power splitter 113, the optical modulator 114, and the multi-channel optical fiber array 116. Alternatively, in a third implementation, the optoelectrical switching device 11 may include the light source pool 112, the optical power splitter 113, the optical modulator 114, and the wavelength division multiplexer 115. Alternatively, the three implementations may be freely combined.

The light source pool 112 may include at least one optoelectrical assembly 111. Each optoelectrical assembly 111 is configured to output light (for example, laser or fluorescence) of one wavelength, and wavelengths of output light output by different optoelectrical assemblies 111 may be the same or different. The optical power splitter 113 may split, based on an optical power, one path of output light output by one optoelectrical assembly 111, to output a plurality of paths of output light to the plurality of optical modulators 114. The first optical-electrical switching chip 117 controls each optical modulator 114 to modulate one path of output light of the optical power splitter 113, to output one optical signal. Each wavelength division multiplexer 115 is configured to multiplex a plurality of optical signals of different wavelengths, to transmit a plurality of optical signals to a receive end 12 in a coarse wavelength division multiplexing (coarse wavelength division multiplexing, CWDM) manner through one optical fiber, thereby reducing a quantity of optical fibers. The multiplexing herein may also be medium wavelength division multiplexing (medium wavelength division multiplexing, MWDM), lane wavelength division multiplexing (lane wavelength division multiplexing, LWDM), dense wavelength division multiplexing (dense wavelength division multiplexing, DWDM), or the like based on different wavelength combinations of a laser device, and may also be a combination of the foregoing different wavelength division multiplexing based on an actual application. The optical fiber array 116 is configured to couple and output optical signals of a plurality of wavelengths through a multi-fiber push on (multi-fiber push on, MPO) connector, to transmit a plurality of optical signals to the receive end 12 through a parallel single-mode optical fiber (parallel single-mode fiber, PSM). A second optical-electrical switching chip 121 of the receive end 12 demodulates the optical signal received by a high-speed optical module 122. For example, if each channel of the optical modulator 114 is 100 Gbps, the high-speed optical module 122 corresponding to a PSM solution may be a 400 G DR4 optical module. Therefore, the high-speed optical module 122 corresponding to a CWDM solution corresponding to each 100 G channel may be a 400 G FR4 optical module. For example, if each channel of the optical modulator 114 is 50 Gbps, and each optical fiber array 116 is connected to eight silicon photonic links of the optical modulator 114, the high-speed optical module 122 corresponding to an LWDM solution may be a 400 G LR8 optical module. In addition, if the receive end 12 is also located on another optoelectrical switching device similar to the optoelectrical switching device 11, the high-speed optical module 122 may also be a silicon photonic receive end on a corresponding optical modulator, and is configured to receive and recover a plurality of optical signals.

The controller 118 may determine a board control signal based on whether a value of an optical power output by the optoelectrical switching device 11 meets a requirement, and output the board control signal to the controller of the optoelectrical assembly 111 to request adjustment of an output optical power output by the optoelectrical assembly 111, or output the board control signal to the controller of the light source pool 112 to request adjustment of an output optical power output by the light source pool 112, to increase or decrease the optical power output by the optoelectrical switching device 11, or decrease the output optical power to zero.

Usually, a power supply or a power supply interface in the optoelectrical assembly 111 or the light source pool 112 is located in the optoelectrical switching device 11, and in particular, is located on a board of the optoelectrical switching device 11. Particularly, a compact parallel multi-path drive with high driving efficiency on the light source pool 112 or the optoelectrical assembly 111 is located on the board of the optoelectrical switching device 11.

In a co-packaged optics, near-packaged optics, or on-board optics communication system of the optoelectrical switching device 11, the light source pool 112 or the optoelectrical assembly 111, as a pluggable module, may be configured to provide an external high-power light source for the co-packaged optics, near-packaged optics, or on-board optics communication system. The co-packaged optics, near-packaged optics, or on-board optics communication system can implement optical communication of 1.6 Tbps, 3.2 Tbps, ..., 25.6 Tbps, 21.2 Tbps, or even higher capacity. The optoelectrical assembly 111, the light source pool 112, or the optoelectrical switching device 11 is configured to output light to a plurality of silicon photonic links, and has a high output optical power of up to about 100 mW. Driving efficiency can be improved, to reduce power consumption of the entire optoelectrical switching device 11. It is of great significance to power consumption and a heat dissipation design of the entire co-packaged optics, near-packaged optics, or on-board optics communication system. For a 10 W light source pool, power consumption of nearly 3 W can be reduced by using the optoelectrical assembly in this application. This can greatly improve a thermal design, reliability, and external power supply pressure of a product, greatly prolong service life, and further improve comprehensive competitiveness of the product. In addition, a compact structure of a drive circuit of the light source pool 112 or the optoelectrical assembly 111 can improve panel utilization of the optoelectrical switching device 11, help miniaturize a device and improve a communication capacity of the system, and further improve comprehensive competitiveness of a product.

The following describes possible structures of the optoelectrical assembly provided in embodiments of this application.

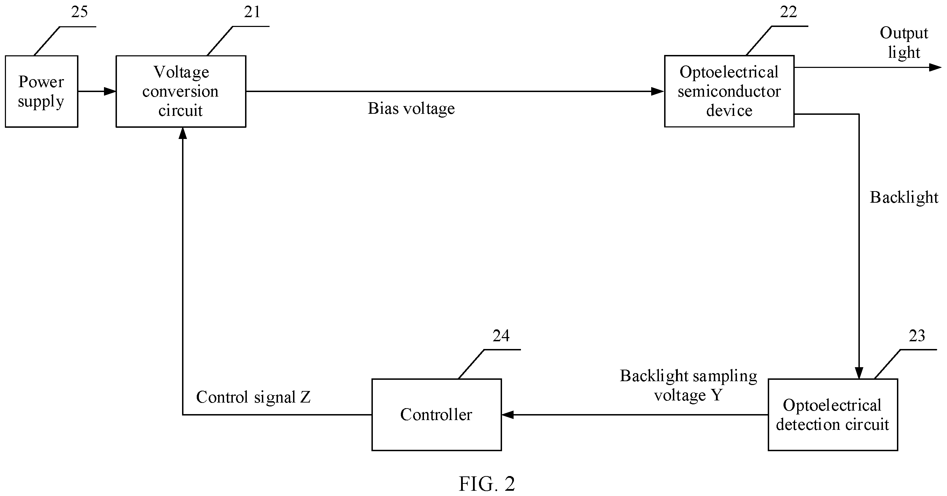

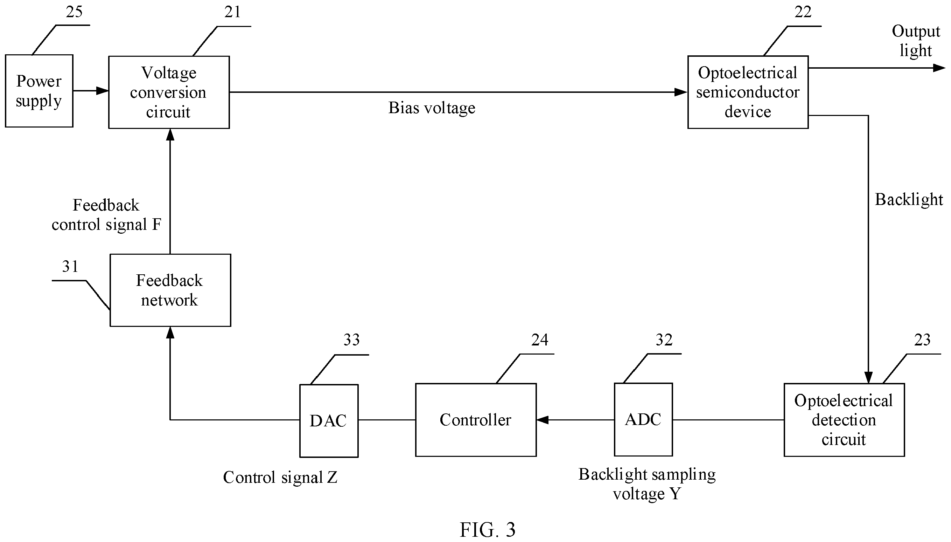

As shown in FIG. 2 and FIG. 3, the optoelectrical assembly includes a voltage conversion circuit 21, an optoelectrical semiconductor device 22, an optoelectrical detection circuit 23, and a controller 24. Optionally, as shown in FIG. 3, the optoelectrical assembly may further include a feedback network 31. When the controller 24 does not have an analog-to-digital conversion interface or a digital-to-analog conversion interface, or when resources of the analog-to-digital conversion interface and the digital-to-analog conversion interface of the controller 24 are insufficient, the optoelectrical assembly may further include an analog-to-digital converter (analog-to-digital converter, ADC) 32 and a digital-to-analog converter (digital-to-analog converter, DAC) 33. When the controller 24 has an analog-to-digital conversion interface (in other words, an analog signal may be directly input) and a digital-to-analog conversion interface (in other words, an analog signal may be directly output), or when resources of the analog-to-digital conversion interface and the digital-to-analog conversion interface of the controller 24 are sufficient, an ADC 32 may be an analog-to-digital conversion interface in the controller 24, and a DAC 33 may be a digital-to-analog conversion interface in the controller 24.

A power supply 25 may supply power to the entire optoelectrical assembly through M ($M \geq 1$) power supply interfaces, and power supply voltages of the M power supply interfaces may be the same or different. A common optoelectrical assembly is used as an example, a supply voltage of the power supply 25 may be a fixed voltage of 3.3 V

The voltage conversion circuit 21 may be an adjustable voltage source, a DC-DC conversion circuit, a DC-DC conversion chip, or a device or component with an adjustable voltage output. An input power supply voltage may be converted into W ($W \geq 1$) bias voltages through DC-DC conversion, and the bias voltage is output to the optoelectrical semiconductor device 22, to drive the optoelectrical semiconductor device 22. In addition, the bias voltage output by the voltage conversion circuit 21 may be separately adjusted based on W control signals Z output by the controller 24, to adjust an output optical power output by the optoelectrical semiconductor device 22. The voltage conversion circuit 21 may be used as a unique bias adjustment circuit of the optoelectrical semiconductor device 22. To be specific, the output optical power of the optoelectrical semiconductor device 22 is controlled by only the bias voltage output by the voltage conversion circuit 21. Each bias voltage output by the voltage conversion circuit 21 needs to be greater than 1.0 V, and the power supply voltage Vcc of the power supply 25 needs to be greater than 1.3 V, to turn on the optoelectrical semiconductor device 22 to operate normally. Each bias voltage output by the voltage conversion circuit 21 needs to be less than 0.9*Vcc, to ensure that the voltage conversion circuit 21 has high energy conversion efficiency when performing voltage conversion.

The bias adjustment circuit is a circuit, for example, an adjustable voltage source or an adjustable current source, that is configured to adjust a bias voltage or a bias current of the optoelectrical semiconductor device.

Compared with the conventional technology in which the adjustable current source provides a drive current to the optoelectrical semiconductor device 22, in this technology, the voltage conversion circuit 21 provides the bias voltage to the optoelectrical semiconductor device 22. This can improve conversion efficiency. A reason is that the solution provided in this embodiment of this application may be applied to an application scenario with a high power and a high drive current. The optoelectrical assembly, the light source pool, or the optoelectrical switching device needs to output light to a plurality of silicon photonic links, has a high output optical power of up to about 100 mW, and requires high carrier density, that is, a high drive current needs to be injected. However, it can be learned from analysis on that the adjustable current source provides the drive current to the optoelectrical semiconductor device, that a larger drive current indicates a larger additional voltage drop generated by a current sampling circuit, and lower conversion efficiency of the entire optoelectrical assembly. The voltage conversion circuit (for example, the DC-DC conversion circuit) 21 provides a bias voltage to the optoelectrical semiconductor device 22. In essence, voltage conversion is implemented through charging and discharging of a high-frequency switch, an inductor, a capacitor, a transformer, or the like. Therefore, no large additional voltage drop is generated, and conversion efficiency can reach 90% or even 93%.

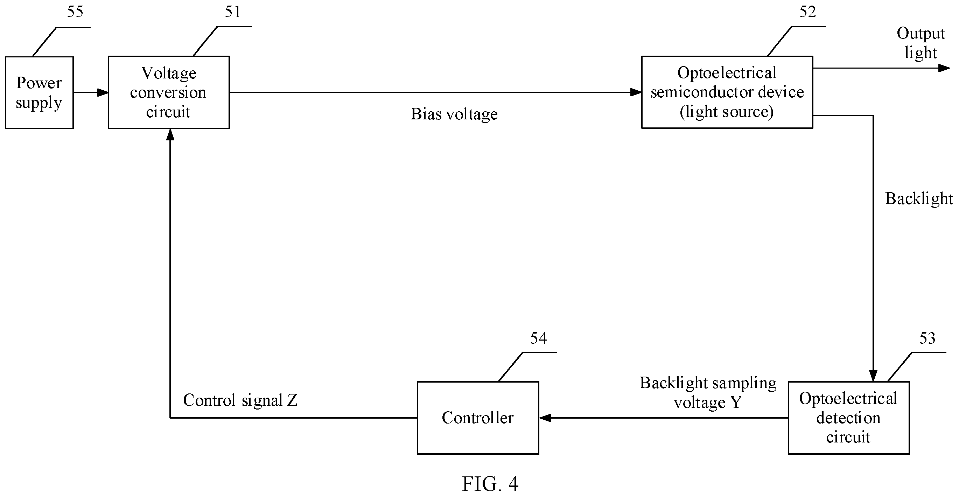

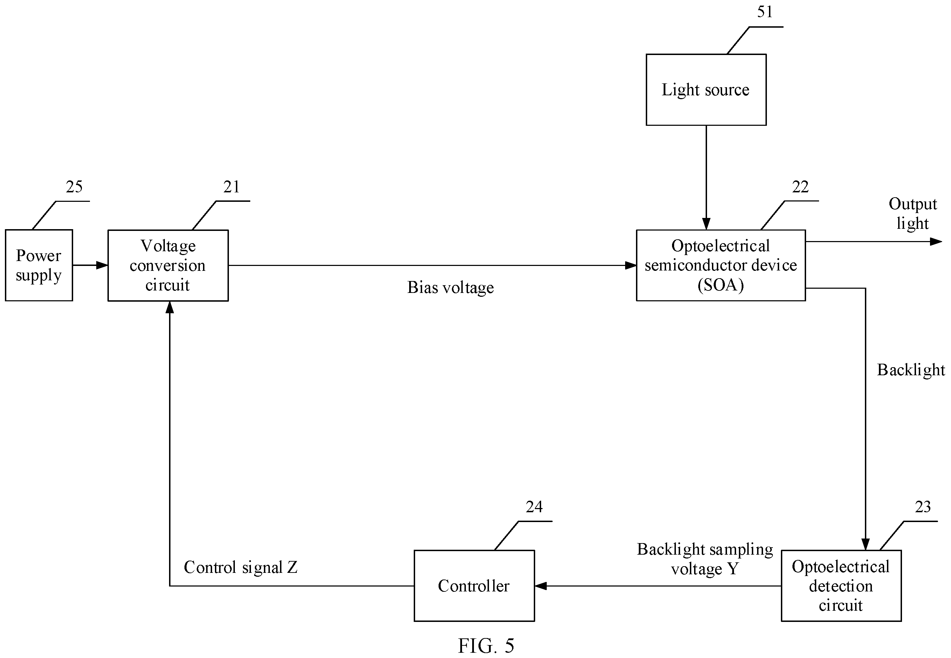

As shown in FIG. 4, the optoelectrical semiconductor device 22 may be a light source (for example, an LED, a laser, or a lidar). In this case, the bias voltage is used to drive the optoelectrical semiconductor device 22 to emit light. Alternatively, as shown in FIG. 5, the optoelectrical semiconductor device 22 may be an SOA. In this case, the optoelectrical semiconductor device 22 is further coupled to a light source 51. The light source 51 may be an external light source or may be a light source in the optoelectrical assembly. The bias voltage is used to drive the optoelectrical semiconductor device 22 to amplify the light output by the light source 51. The optoelectrical semiconductor device 22 is located in P load links, and a quantity of optoelectrical semiconductor devices 22 may be N (N≥1). The output light of the optoelectrical semiconductor device 22 includes two parts. The first part is output light (for example, laser and fluorescence) of the entire optoelectrical assembly, and the second part (which is usually backlight) is output to the optoelectrical detection circuit 23 for detecting an optical power of the optoelectrical semiconductor device 22. A differential resistance value Rdiff of the optoelectrical semiconductor device 22 within a range of a target optical power cannot be excessively small or large, to ensure that an APC loop operates within a normal range and a current-voltage relationship curve of the optoelectrical semiconductor device 22 has smooth linearity. The differential resistance value Rdiff of the optoelectrical semiconductor device 22 within the range of the target optical power satisfies 0.1 Ω≤Rdiff≤50 Ω.

In this embodiment of this application, the target optical power is usually determined based on an optical power budget range of an optical link of a system in which the optoelectrical assembly, a light source pool, or an optoelectrical switching device is located, to ensure that the system can be in a normal operating state in which a bit error rate is less than a specific index. For example, to support normal operation of four 100 Gpbs silicon photonic modulation links, the target optical power of the optoelectrical assembly, the light source pool, or the optoelectrical switching device may range from 50 mW to 150 mW. Further, the target optical power of the optoelectrical assembly, the light source pool, or the optoelectrical switching device may range from 64 mW to 120 mW. Further, the target optical power of the optoelectrical assembly, the light source pool, or the optoelectrical switching device may range from 64 mW to 100 mW. This reduces power consumption of the system when optical power budget of the optical link of the system is ensured. For another example, to support normal operation of eight 100 Gpbs silicon photonic modulation links, the target optical power of the optoelectrical assembly, the light source pool, or the optoelectrical switching device may range from 150 mW to 300 mW. Further, the target optical power of the optoelectrical assembly, the light source pool, or the optoelectrical switching device may range from 150 mW to 250 mW.

In this embodiment of this application, the differential resistance value Rdiff of the optoelectrical semiconductor device within the range of the target optical power is dV/dI, where dI is a current variation generated by a current flowing through the optoelectrical semiconductor device when an input voltage generates a voltage variation dV That is, the differential resistance value Rdiff is a ratio of the voltage variation dV to the current variation dI corresponding to the voltage variation dV

It should be noted that, in this embodiment of this application, to keep an output laser optical power stable within a specific range, the controller 24 performs APC. The APC loop is a loop formed by the voltage conversion circuit 21, the optoelectrical semiconductor device 22, the optoelectrical detection circuit 23, and the controller 24, and the controller 24 can detect the output optical power output by the optoelectrical semiconductor device 22 through the optoelectrical detection circuit 23. Further, the bias voltage output by the voltage conversion circuit 21 to the optoelectrical semiconductor device 22 is controlled to adjust the output optical power output by the optoelectrical semiconductor device 22, that is, the controller 24 may implement APC on the optoelectrical semiconductor device 22. That the APC loop operates within the normal range means that the bias voltage output by the voltage conversion circuit 21 is moderate, so that the optoelectrical semiconductor device 22 can normally emit light, and the output optical power output by the optoelectrical semiconductor device 22 is within the range of the target optical power. The load link includes a device coupled to a voltage output end of the voltage conversion circuit 21, for example, includes the optoelectrical semiconductor device 22.

When the differential resistance value Rdiff of the optoelectrical semiconductor device 22 within the range of the target optical power is excessively large, the optoelectrical semiconductor device 22 needs to input a large bias voltage variation to enable an equivalent current of the optoelectrical semiconductor device 22 to generate a small current variation. In other words, when the bias voltage input to the optoelectrical semiconductor device 22 has a large variation, a variation of the equivalent current flowing through the optoelectrical semiconductor device 22 is small, and correspondingly, a carrier concentration variation is small and is insufficient to effectively adjust the output optical power output by the optoelectrical semiconductor device 22. For example, it is assumed that the differential resistance value Rdiff=100 Q. A voltage variation of 100 mV is required to generate a current variation of 1 mA, which usually corresponds to a state before a turn-on threshold of the optoelectrical semiconductor device 22 is reached, and cannot be used for normal operation of the APC loop. Even if the optoelectrical semiconductor device 22 is in a lasing state above the turn-on threshold at this time, a voltage variation of 1 V is required to realize a current variation of 10 mA. In an actual application process, it is difficult to apply this optoelectrical semiconductor device due to limitations of a voltage output capability and voltage conversion efficiency of the voltage conversion circuit 21.

When the differential resistance value Rdiff of the optoelectrical semiconductor device 22 within the range of the target optical power is excessively small, a small bias voltage variation input to the optoelectrical semiconductor device 22 may cause a current of the optoelectrical semiconductor device 22 to generate a large current variation, and correspondingly, a carrier concentration variation is extremely large. The output optical power output by the optoelectrical semiconductor device 22 changes greatly, and may fall within a range within which the optical power is excessively large or excessively small, or may fall within a roll-off operating range of the optoelectrical semiconductor device 22, (that is, the output optical power decreases with an increase of an injection current). Therefore, it is difficult to apply to APC. For example, it is assumed that the differential resistance value of the optoelectrical semiconductor device 22 within the range of the target optical power is 0.01 Ω. When an input voltage variation is 1 mV, a current variation of a current flowing through the optoelectrical semiconductor device 22 is 100 mA. This is unacceptable for feedback adjustment of the APC loop.

Therefore, in this embodiment of this application, the differential resistance value Rdiff of the optoelectrical semiconductor device 22 within the range of the target optical power meets the condition: 0.1 Ω≤Rdiff≤50 Ω. For example, the differential resistance value of the optoelectrical semiconductor device 22 within the range of the target optical power is 0.2 Q. When a variation of the bias voltage output by the voltage conversion circuit 21 is 1 mV, a variation of a current flowing through the optoelectrical semiconductor device 22 is 5 mA. In an APC loop adjustment process, it is applicable to a case in which an equivalent adjustment current step is large. For example, the differential resistance value of the optoelectrical semiconductor device 22 within the range of the target optical power is 2 Q. When a variation of the bias voltage output by the voltage conversion circuit 21 is 1 mV, a variation of a current flowing through the optoelectrical semiconductor device 22 is 0.5 mA. In an APC loop adjustment process, it is applicable to a case in which an equivalent adjustment current step is small. For example, the differential resistance value of the optoelectrical semiconductor device 22 within the range of the target optical power is 20 Q. When a variation of the bias voltage output by the voltage conversion circuit 21 is 1 mV, a variation of a current flowing through the optoelectrical semiconductor device 22 is 0.05 mA. In an APC loop adjustment process, it is applicable to a case in which an equivalent adjustment current step is fine.

In addition, when the APC loop operates within the normal range, a resistance value of the optoelectrical semiconductor device 22 within the range of the target optical power is less than or equal to 60 Q. When a resistance value of the optoelectrical semiconductor device 22 is small, it indicates that the optoelectrical semiconductor device 22 is well turned on and enters a good lasing state. In this case, a current-voltage relationship curve of the optoelectrical semiconductor device 22 changes smoothly and has an obvious linear characteristic, the differential resistance value of the optoelectrical semiconductor device 22 is also moderate, and a change of the bias voltage of the optoelectrical semiconductor device 22 may cause a linear change of a corresponding current of the optoelectrical semiconductor device 22, and then cause a linear change of carrier concentration of the optoelectrical semiconductor device 22. This can linearly change the output optical power output by the optoelectrical semiconductor device 22. On the contrary, when a resistance value of the optoelectrical semiconductor device 22 is large, it indicates that the optoelectrical semiconductor device 22 is in a state near threshold, and a current-voltage relationship curve in the state near the threshold changes steeply and has an unobvious linear characteristic. In this case, a change of the bias voltage of the optoelectrical semiconductor device 22 may cause a non-linear change of the corresponding current of the optoelectrical semiconductor device 22, and then cause a non-linear change of carrier concentration of the optoelectrical semiconductor device 22. It is difficult to linearly change the output optical power output by the optoelectrical semiconductor device 22. The optoelectrical semiconductor device 22 is not suitable for operation within the range.

In addition, when the APC loop operates within the normal range, to ensure that a voltage step and a current step corresponding to the voltage step obtained during APC loop adjustment change evenly, to cause a linear change of the carrier concentration of the optoelectrical semiconductor device 22 the output optical power output by the optoelectrical semiconductor device 22 may be linearly changed, and the selected differential resistance of the optoelectrical semiconductor device 22 within the range of the target optical power may be even, that is, a differential resistance value Rdiffsub of the optoelectrical semiconductor device 22 within a specific sub-range of the target optical power is close to an average differential resistance value Rdiffavg within the range of the target optical power. The average differential resistance value Rdiffavg indicates a ratio of a bias voltage variation dV corresponding to a lower optical power limit and an upper optical power limit within the range of the target optical power to a corresponding current variation dI.

For example, a differential resistance value Rdiffsub within a specific sub-range of the target optical power satisfies max(0.02*Rdiffavg, 0.1 Ω)≤Rdiffsub≤min(50*Rdiffavg, 50 Ω), where max(0.02*Rdiffavg, 0.1 S2) indicates a larger value of 0.02*Rdiffavg and 0.1 Ω, and min(50*Rdiffavg, 50 S2) indicates a smaller value of 50*Rdiffavg and 50 Ω.

For example, a differential resistance value Rdiffsub within a specific sub-range of the target optical power satisfies max(0.1*Rdiffavg, 0.1 Ω)≤Rdiffsub≤min(10*Rdiffavg, 50 Ω), where max(0.1*Rdiffavg, 0.1 S2) indicates a larger value of 0.1*Rdiffavg and 0.1 Ω, and min(10*Rdiffavg, 50 S2) indicates a smaller value of 10*Rdiffavg and 50 Ω.

For example, a differential resistance value Rdiffsub within a specific sub-range of the target optical power satisfies max(0.2*Rdiffavg, 0.1 Ω)≤Rdiffsub≤min(5*Rdiffavg, 50 S2), where max(0.2*Rdiffavg, 0.1 S2) indicates a larger value of 0.2*Rdiffavg and 0.1 Ω, and min(5*Rdiffavg, 50 S2) indicates a smaller value of 5*Rdiffavg and 50 Q.

For example, a differential resistance value Rdiffsub within a specific sub-range of the target optical power satisfies max(0.5*Rdiffavg, 0.1 Ω)≤Rdiffsub≤min(2*Rdiffavg, 50 Ω), where max(0.5*Rdiffavg, 0.1 S2) indicates a larger value of 0.5*Rdiffavg and 0.1 Ω, and min(2*Rdiffavg, 50 S2) indicates a smaller value of 2*Rdiffavg and 50 Q.

For example, a differential resistance value Rdiffsub within a specific sub-range of the target optical power satisfies max(0.8*Rdiffavg, 0.1 Ω)≤Rdiffsub≤min(1.25*Rdiffavg, 50 Ω), where max(0.8*Rdiffavg, 0.1 S2) indicates a larger value of 0.8*Rdiffavg and 0.1 Ω, and min(1.25*Rdiffavg, 50 S2) indicates a smaller value of 1.25*Rdiffavg and 50 Q.

For example, a differential resistance value Rdiffsub within a specific sub-range of the target optical power satisfies max(0.5*Rdiffavg, 0.1 Ω)≤Rdiffsub≤min(4*Rdiffavg, 50 Ω), where max(0.5*Rdiffavg, 0.1 S2) indicates a larger value of 0.5*Rdiffavg and 0.1 Ω, and min(4*Rdiffavg, 50 S2) indicates a smaller value of 4*Rdiffavg and 50 Ω. For another example, under the target optical power, the differential resistance value of the optoelectrical semiconductor device 22 under the bias voltage is Rdiff1, which satisfies 0.1 Ω≤Rdiff1≤50 Ω. In addition, within the range of the target optical power, the differential resistance value Rdiff of the optoelectrical semiconductor device 22 satisfies max(0.1*Rdiffl, 0.1 Ω)≤Rdiff≤min(10*Rdiff1, 50 Ω), where max(0.1*Rdiffl, 0.1 Ω) indicates a larger value of 0.1*Rdiff1 and 0.1 Ω, and min(10*Rdiff1, 50 Q) indicates a smaller value of 10*Rdiff1 and 50 Q.

For example, under the target optical power, the differential resistance value of the optoelectrical semiconductor device 22 under the bias voltage is Rdiff1, which satisfies 0.1 Ω≤Rdiff1≤50 Ω. In addition, within the range of the target optical power, the differential resistance value Rdiff of the optoelectrical semiconductor device 22 satisfies max(0.2*Rdiff1, 0.1 Ω)≤Rdiff≤min(5*Rdiff1, 50 Ω), where max(0.2*Rdiff1, 0.1 Ω) indicates a larger value of 0.2*Rdiff1 and 0.1 Ω, and min(5*Rdiff1, 50 S2) indicates a smaller value of 5*Rdiff1 and 50 Q.

For example, under the target optical power, the differential resistance value of the optoelectrical semiconductor device 22 under the bias voltage is Rdiff1, which satisfies 0.1 Ω≤Rdiff1≤50 Ω. In addition, within the range of the target optical power, the differential resistance value Rdiff of the optoelectrical semiconductor device 22 satisfies max(0.5*Rdiff1, 0.1 Ω)≤Rdiff≤min(2*Rdiff1, 50 Ω), where max(0.5*Rdiff1, 0.1 Ω) indicates a larger value of 0.5*Rdiff1 and 0.1 Ω, and min(2*Rdiff1, 50 S2) indicates a smaller value of 2*Rdiff1 and 50 Q.

For example, under the target optical power, the differential resistance value of the optoelectrical semiconductor device 22 under the bias voltage is Rdiff1, which satisfies 0.1 Ω≤Rdiff1≤50 Ω. In addition, within the range of the target optical power, the differential resistance value Rdiff of the optoelectrical semiconductor device 22 satisfies max(0.8*Rdiff1, 0.1 Ω)≤Rdiff≤min(1.25*Rdiff1, 50 Ω), where max(0.8*Rdiff1, 0.1 Ω) indicates a larger value of 0.8*Rdiff1 and 0.1 Ω, and min(1.25*Rdiff1, 50 S2) indicates a smaller value of 1.25*Rdiff1 and 50 Q.

For example, under the target optical power, the differential resistance value of the optoelectrical semiconductor device 22 under the bias voltage is Rdiff1, which satisfies 0.1 Ω≤Rdiff1≤50 Ω. In addition, within the range of the target optical power, the differential resistance value Rdiff of the optoelectrical semiconductor device 22 satisfies max(0.5*Rdiff1, 0.1 Ω)≤Rdiff≤min(4*Rdiff1, 50 Ω), where max(0.5*Rdiff1, 0.1 Ω) indicates a larger value of 0.5*Rdiff1 and 0.1 Ω, and min(4*Rdiff1, 50 S2) indicates a smaller value of 4*Rdiff1 and 50 Q.

In this embodiment of this application, a relationship between a quantity P of load links, a quantity N of optoelectrical semiconductor devices 22, and a quantity W of bias voltages output by the voltage conversion circuit 21 may be correspondingly adjusted based on different serial-parallel connection relationships of load links and serial-parallel connection relationships of different optoelectrical semiconductor devices 22 in a same load link. Usually, P=N=W, to be specific, each bias voltage output by the voltage conversion circuit 21 drives one load link, and there is one optoelectrical semiconductor device 22 on each load link. Particularly, if the optoelectrical semiconductor device 22 has good device performance consistency, a plurality of load links may be driven in parallel on one voltage output end of the voltage conversion circuit 21, and there is at least one optoelectrical semiconductor device 22 in each link. For example, one voltage output end of the voltage conversion circuit 21 drives two load links connected in parallel, and each load link includes one optoelectrical semiconductor device 22. In this case, W=P/2, and P=N. For another example, one voltage output end of the voltage conversion circuit 21 drives two load links connected in parallel, and two optoelectrical semiconductor devices are connected in series to each link. In this case, W=P/2, and P=N/2.

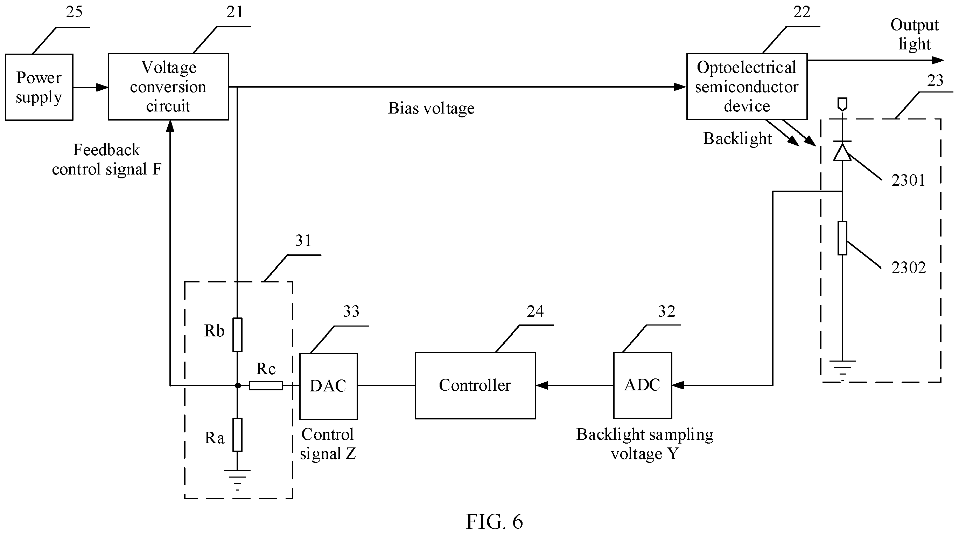

The optoelectrical detection circuit 23 is configured to: receive light output by the optoelectrical semiconductor device 22, detect the output optical power output by the optoelectrical semiconductor device 22, and output a detection signal to the controller 24, where the detection signal may indicate the output optical power output by the optoelectrical semiconductor device 22. The optoelectrical detection circuit 23 usually detects a backlight optical power output by the optoelectrical semiconductor device 22 in the N detection links, to detect the output optical power output by the optoelectrical semiconductor device 22. As shown in FIG. 6, the optoelectrical detection circuit 23 includes an optoelectrical detector 2301 and a sampling resistor 2302 that are connected in series. The optoelectrical detector 2301 that is reversely biased when irradiated by backlight generates a photocurrent. When the photocurrent passes through the sampling resistor 2302, a detection signal that is proportional to the photocurrent (a backlight sampling voltage Y is used as an example in this application, but is not intended to be limited thereto) is generated. A value of the photocurrent is proportional to the optical power of the backlight. Therefore, the backlight sampling voltage Y is proportional to the output optical power. The backlight sampling voltage Y output by the optoelectrical detection circuit 23 is an analog signal.

The ADC 32 is configured to convert the backlight sampling voltage Y generated by the optoelectrical detection circuit 23 from an analog signal to a digital signal. The ADC 32 may include a single ADC component or a plurality of ADC components, and specifications of all ADC components may be the same or different.

When the ADC 32 includes a single ADC component, a quantity Q of input analog channels supported by the ADC component is greater than or equal to N, and a quantity R of output digital channels supported by the ADC component is greater than or equal to S, where S (S≥1) is a quantity of digital channels, of the controller 24, that are coupled to the ADC 32. Particularly, a quantity Q of input analog channels supported by the single ADC component is N, and a quantity R of supported output digital channels is S=1.

When the ADC 32 includes J (J≥2) ADC components, a quantity of input analog channels supported by an $i^{th}$ (2≤i≤J) ADC component is Qi, and a quantity of output digital channels supported by the $i^{th}$ ADC component is Ri. In this case, Q1+...+Qi+...+QJ≥N and R1+...+Ri+...+RJ≥S need to be satisfied. Particularly, a quantity of input analog channels supported by each of the J ADC components satisfies Q1+...+Qi+...+QJ=N, and a quantity of output digital channels supported by each of the J ADC components satisfies Ri=1 (2≤i≤J).

The controller 24 is configured to provide signal processing and control for an entire drive system according to a control processing algorithm, to perform a control method for the optoelectrical assembly. Specifically, the controller 24 may determine the control signal Z based on the detection signal (for example, the backlight sampling voltage Y) output by the optoelectrical detection circuit 23, and output the control signal Z to a feedback end of the voltage conversion circuit 21, to adjust the bias voltage output by the voltage conversion circuit 21, that is, implement the APC. The controller 24 may also be used for automatic gain control (AGC), optical pulse output control, and the like. For example, the controller 24 may calculate the control signal Z according to a formula Z=B*Y+C, or obtain the control signal Z through table lookup, where B is an adjustment rule corresponding to the backlight sampling voltage Y, C is a fitting constant, and values of B and C may be obtained by searching for a pre-calibrated or pre-fitted table in the controller 24, or may be obtained through real-time calculation. Further, A, B, and C in the pre-calibrated or pre-fitted table in the controller 24 may be corrected based on an actual accurate input. In other words, there is a linear relationship between the control signal Z and the detection signal (the backlight sampling voltage Y). This simplifies an algorithm design of the controller 24, and facilitates control on the bias voltage.

Further, the controller 24 may further obtain load link information (how to obtain the load link information is described below), where the load link information includes a value of the bias voltage. The load link information may be a digital signal or an analog signal. The controller 24 may determine the control signal Z based on the load link information X and the detection signal (for example, the backlight sampling voltage Y), and output the control signal Z to the feedback end of the voltage conversion circuit 21, to adjust the bias voltage output by the voltage conversion circuit 21.

If the load link information indicates an actual value of the bias voltage, a deviation between a theoretical value of the bias voltage and the actual value caused by a device parameter deviation and fluctuation in the feedback network 31 can be eliminated, and a more accurate input is provided for the controller 24 to obtain the control signal Z. For example, the controller 24 may calculate the control signal Z according to a formula Z=A*X+B*Y+C, or obtain the control signal Z through table lookup, where A is an adjustment rule corresponding to load link information X, B is an adjustment rule corresponding to the backlight sampling voltage Y, C is a fitting constant, and values of A, B, and C may be obtained by searching for a pre-calibrated or pre-fitted table in the controller 24, or may be obtained through real-time calculation. Further, A, B, and C in the pre-calibrated or pre-fitted table in the controller 24 may be corrected based on an actual accurate input.

A bit width of a digital signal processed by the controller 24 is at least 6 bits, and a voltage variation corresponding to a minimum weight bit can meet a requirement for fine adjustment of the bias voltage output by the voltage conversion circuit 21, to implement accurate control on the bias voltage output by the voltage conversion circuit 21. If a digital signal processed by the controller 24 has only 4 bits, for example, an internal reference voltage 2.5 V of the controller 24 corresponds to a maximum value of a four-bit binary number, a voltage variation corresponding to a minimum weight bit of the control signal Z output by the controller 24 is 2.5 V/2^4≈156 mV. This voltage adjustment precision is unacceptable. If a bit width of a digital signal processed by the controller 24 is 6 bits, for example, an internal reference voltage 2.5 V of the controller 24 corresponds to a maximum value of a 6-bit binary number, a voltage variation corresponding to a minimum weight bit of the control signal Z output by the controller 24 is 2.5 V/2^6≈39 mV Even if precision of the bias voltage output by the voltage conversion circuit 21 is the same as the voltage variation 39 mV corresponding to the minimum weight bit of the control signal Z, when the differential resistance value Rdiff of the optoelectrical semiconductor device 22 within the range of the target optical power is 10 Q and a bias voltage variation output by the voltage conversion circuit 21 is 39 mV, the current variation of the current flowing through the optoelectrical semiconductor device 22 is 3.9 mA. This may be considered as a case in which an equivalent adjustment current step is large in APC loop control, but it is also acceptable. If a bit width of a digital signal processed by the controller 24 is 8 bits, for example, an internal reference voltage 2.5 V of the controller 24 corresponds to a maximum value of an 8-bit binary number, a voltage variation corresponding to a minimum weight bit of the control signal Z output by the controller 24 is 2.5 V/2^8=9.8 mV. Even if precision of the bias voltage output by the voltage conversion circuit 21 is the same as the voltage variation 9.8 mV corresponding to the minimum weight bit of the control signal Z, when the differential resistance value Rdiff of the optoelectrical semiconductor device 22 within the range of the target optical power is 10 Q and a bias voltage variation output by the voltage conversion circuit 21 is 9.8 mV, the current variation of the current flowing through the optoelectrical semiconductor device 22 is 0.98 mA. This may be considered as a case in which an equivalent adjustment current step is small in APC loop control, and it is acceptable. In combination with the feedback network 31, precision of the control signal Z can be further improved, and precision of the bias voltage output by the voltage conversion circuit 21 can be further improved, that is, resolution of the analog-to-digital conversion interface in the DAC 33 or the controller 24 is equivalently improved.

The quantity of digital channels, of the controller 24, that are coupled to the ADC 32 is S (S≥1), and the quantity of analog channels, of the controller 24, that are coupled to the DAC 33 is T (T≥1). The controller 24 may be a micro-control unit (micro-control unit, MCU), a field-programmable gate array (field-programmable gate array, FPGA), or the like.

The DAC 33 is configured to convert the control signal Z generated by the controller 24 from a digital signal to an analog signal. The DAC 33 may include a single DAC component or a plurality of DAC components, and specifications of all DAC components may be the same or different.

When the DAC 33 includes a single DAC component, a quantity U of input digital channels supported by the DAC component is greater than or equal to T, and a quantity V of output analog channels supported by the DAC component is greater than W. T (T≥1) is a quantity of digital channels, of the controller 24, that are coupled to the DAC 33. Particularly, a quantity U of input digital channels supported by the single DAC component is T=1, and a quantity V of output analog channels supported by the single DAC component is W.

When the DAC 33 includes L (L≥2) DAC components, a quantity of input digital channels supported by an $i^{th}$ (2≤i≤L) DAC component is Ui, and a quantity of output analog channels supported by the $i^{th}$ DAC component is Vi. In this case, U1+...+Ui+...+UL≥T and V1+...+Vi+...+VL≥W need to be satisfied. Particularly, a quantity of input digital channels supported by each of the foregoing L DAC components satisfies Ui=1 (2≤i≤L), and a quantity of output analog channels supported by each of the foregoing L DAC components satisfies V1+...+Vi+...+VL=W.

It should be noted that, to match the bit width, that is, at least 6 bits, of the digital signal processed by the controller 24, bit widths of the DAC 33 and the ADC 32 may be consistent with the bit width of the digital signal processed by the controller 24, to ensure adjustment precision. Therefore, the bit widths of the DAC 33 and the ADC 32 are also at least 6 bits.

The feedback network 31 is configured to: increase or decrease a voltage range of the control signal Z to obtain a feedback control signal F, and output the feedback control signal F to the voltage conversion circuit 21, to meet a requirement for a range of a signal input by the voltage conversion circuit 21, and improve precision of the control signal Z. Therefore, the feedback control signal F may be represented as F=E*Z+G, where E is a corresponding adjustment rule of the feedback network 31 for the control signal Z, and G is a fitting constant. In addition, when the voltage conversion circuit 21 is a DC-DC conversion circuit, the DC-DC conversion circuit usually includes an operational amplifier, and the feedback network 31 is coupled to an output end and a feedback end of the operational amplifier, to form a feedback path of the operational amplifier. The feedback network 31 may provide, to the voltage conversion circuit 21, W feedback control signals F corresponding to the W output voltages.

Particularly, when the voltage conversion circuit 21 has a voltage adjustment and transformation frequency input or control end, the controller 24 may further provide another feedback control signal F2 to the voltage conversion circuit 21 based on a circuit status and a characteristic of the voltage conversion circuit 21, to change a voltage adjustment and transformation frequency of the voltage conversion circuit 21. This can improve voltage conversion efficiency of the voltage conversion circuit 21.

The feedback network 31 may be a voltage divider network including a resistor. For example, as shown in FIG. 6, the feedback network includes a resistor Ra, a resistor Rb, and a resistor Rc. A second end of the resistor Ra is grounded, a first end of the resistor Ra, a second end of the resistor Rb, and a first end of the resistor Rc are coupled to the feedback end of the voltage conversion circuit 21, a first end of the resistor Rb is coupled to a bias voltage output end of the voltage conversion circuit 21, and a second end of the resistor Rc is coupled to an output end of the controller 24.

It is assumed that there is a function relationship Vout=f(Vfb) between the bias voltage Vout output by the voltage conversion circuit 21 and the feedback voltage Vfb (namely, a voltage of the feedback control signal F) input from the feedback end of the voltage conversion circuit 21, where f() represents a function, and the function relationship is related to a design of the voltage conversion circuit 21. If the function relationship is a linear relationship, it may be further represented as Vout=a*Vfb+c, where a and c are constant coefficients related to the design of the voltage conversion circuit 21. When the voltage conversion circuit 21 is a DC-DC conversion circuit, a reference voltage Vref (which is usually a fixed value) inside the DC-DC conversion circuit is input from an input end of the operational amplifier in the DC-DC conversion circuit, and a voltage Vfb is input from another input end of the operational amplifier. The voltage Vout, the voltage Vfb, and the reference voltage Vref have the following relationship when Rc is off:

$$Vfb=Vref \hspace{4cm} Formula\ 1$$

$$Vout=Vfb*(Ra+Rb)/Rb \hspace{3cm} Formula\ 2$$

Specifically, in combination with the resistor voltage divider network of the feedback network 31, the following may be obtained:

$$Vout=(Vref/Ra-(Vadj-Vref)/Rc)*Rb+Vref \hspace{2cm} Formula\ 3$$

Vadj is the voltage of the control signal Z output by the DAC 33.

It can be learned from the formula 3 that, for a given resistance Ra, a give resistance Rb, and a given resistance Rc, the output voltage Vout of the DC-DC conversion circuit may be adjusted based on the voltage Vadj of the control signal Z, that is, Vout=f(Vadj), and the control signal Z and the feedback control signal F are in a linear relationship. Therefore, different resistances Ra, resistances Rb, resistances Rc, voltages Vadj, and reference voltages Vref are set, to obtain different voltages Vout.

The feedback network based on the resistor voltage divider network implements a linear increase or decrease of the control signal Z based on the feedback control signal F, to meet the requirement for the range of the signal input by the voltage conversion circuit 21, and improve the precision of the control signal. In addition, the feedback network is simple in design and compact in structure. This facilitates miniaturization of the entire optoelectrical assembly.

It should be noted that, in this application, only one feedback network based on the resistor voltage divider network is provided, and different function relationships Vout=f(Vadj) may be further designed in combination with other devices such as a digital circuit and an analog circuit. In addition, a function relationship Z=g(Y) of the control signal Z may be further determined in combination with the controller 24 and based on the backlight sampling voltage Y, to obtain Vout=f(Vadj)=f(g(Y)).

For example, how the controller 24 calibrates each parameter in the formula Z=B*Y+C is described by using an example in which the controller 24 determines the control signal Z based on the detection signal (for example, the backlight sampling voltage Y) output by the optoelectrical detection circuit 23.

Step 1: The controller 24 outputs the control signal Z. If there is the feedback network 31, the feedback network 31 converts the control signal Z into the feedback control signal F and outputs the feedback control signal F to the voltage conversion circuit 21, to adjust the bias voltage output by the voltage conversion circuit 21. If there is no feedback network 31, the control signal Z is output to the voltage conversion circuit 21, to adjust the bias voltage output by the voltage conversion circuit 21. The bias voltage output by the voltage conversion circuit 21 correspondingly generates a drive current (which may also be referred to as a bias current), and the optoelectrical semiconductor device 22 outputs light (a power accounts for a major part) and backlight (a power accounts for a small part) under the action of the drive current. The output optical power measured by an external optical power detector is P. The optoelectrical detection circuit 23 outputs the backlight sampling voltage Y The backlight sampling voltage Y, the control signal Z, and the optical power P are stored in the controller 24 as a parameter combination (Y, Z, P).

Within the range of the target optical power, a ratio of the backlight optical power output by the optoelectrical semiconductor device 22 to the output optical power P is basically stable, and the backlight optical power is proportional to the backlight sampling voltage Y Therefore, the output optical power P is proportional to the backlight sampling voltage Y Therefore, the parameter combination (Y, Z, P) may be expressed as (Y, Z, P(Y)).

Step 2: The controller 24 changes the output control signal Z, obtains more parameter combinations (Yi, Zi, Pi(Yi)) in the step 1, and stores the parameter combinations in the controller 24, where i is a positive integer. Alternatively, the controller 24 may obtain a new parameter combination through fitting based on a plurality of existing parameter combinations. After obtaining a plurality of combined parameters, the controller 24 may establish a mapping relationship between B, C, Y, and Z in the formula Z=B*Y+C according to a specific algorithm and rule.

Step 3: The controller 24 sets a default parameter combination (Yo, Zo, Po(Y)) based on the target optical power Pg, and is configured to output the control signal Z based on the default parameter combination during initialization, where Po≥Pg.

In an actual system operation process, to keep the output optical power within a preset range, the controller 24 performs APC. The controller 24 obtains the backlight sampling voltage Y in real time, and obtains the control signal Z according to a calibrated formula Z=B*Y+C. Normally, the backlight sampling voltage Y obtained by the controller 24 is stable, and therefore the control signal Z is also stable.

When the output optical power of the optoelectrical semiconductor device 22 decreases due to aging of the device or an increase of ambient temperature, the backlight sampling voltage Yo decreases to Y'. In this case, the controller 24 needs to adjust the control signal Z according to Z=B*Y+C established in the calibration process, so that the bias voltage output by the voltage conversion circuit 21 increases, to provide a larger drive current, increase the carrier concentration, increase the output optical power, and further increase the backlight sampling voltage to Yt. The controller 24 compares Yt with Yo, and continues to adjust the control signal Z if Yt<Yo, so that the bias voltage output by the voltage conversion circuit 21 increases, to provide a larger drive current, and increase the backlight sampling voltage Yt until |Yt-Yo| is less than a set error. The controller continues to adjust the control signal Z if Yt>Yo, so that the bias voltage output by the voltage conversion circuit 21 decreases, to provide a smaller drive current, and decrease the backlight sampling voltage Yt until |Yt-Yo| is less than a set error. An adjustment direction and step of the control signal Z may be dynamically adjusted based on a change trend of the backlight sampling voltage Yt and according to a formula Z=B*Y+C. Finally, the entire system operates under a new parameter combination (Yo, Zt, Po(Yo)).

When the output optical power output by the optoelectrical semiconductor device 22 increases due to a decrease of ambient temperature, the backlight sampling voltage Yo increases to Y'. In this case, the controller 24 needs to adjust the control signal Z according to the formula Z=B*Y+C established in the calibration process, so that the bias voltage output by the voltage conversion circuit 21 decreases, to provide a smaller drive current, decrease the carrier concentration, and further decrease the backlight sampling voltage to Yt. The controller 24 compares Yt with Yo, and continues to adjust the control signal Z if Yt>Yo, so that the bias voltage output by the voltage conversion circuit 21 decreases, to provide a smaller drive current, and decrease the backlight sampling voltage Yt until |Yt-Yo| is less than a set error. The controller continues to adjust the control signal Z if Yt<Yo, so that the bias voltage output by the voltage conversion circuit 21 increases, to provide a larger drive current, and increase the backlight sampling voltage Yt until |Yt-Yo| is less than a set error. An adjustment direction and step of the control signal Z may be dynamically adjusted based on a change trend of the backlight sampling voltage Yt and according to a formula Z=B*Y+C. Finally, the entire system operates under a new parameter combination (Yo, Zt, Po(Yo)).

According to the optoelectrical assembly, the light source pool, and the control method for the optoelectrical assembly provided in embodiments of this application, efficiency of the optoelectrical assembly is improved. The voltage conversion circuit provides the bias voltage to the optoelectrical semiconductor device, to adjust the output optical power output by the optoelectrical semiconductor device. The optoelectrical detection circuit receives the light output by the optoelectrical semiconductor device, detects the output optical power output by the optoelectrical semiconductor device, and outputs the detection signal to the controller. The controller may determine, based on the detection signal, the control signal used to adjust the bias voltage, and send the control signal to the voltage conversion circuit. Another detection circuit does not need to be coupled between the voltage conversion circuit and the optoelectrical semiconductor device, an additional power output by the voltage conversion circuit is not consumed, and most of the power output by the voltage conversion circuit is converted into the output optical power output by the optoelectrical semiconductor device. Therefore, this can improve efficiency of the optoelectrical assembly.

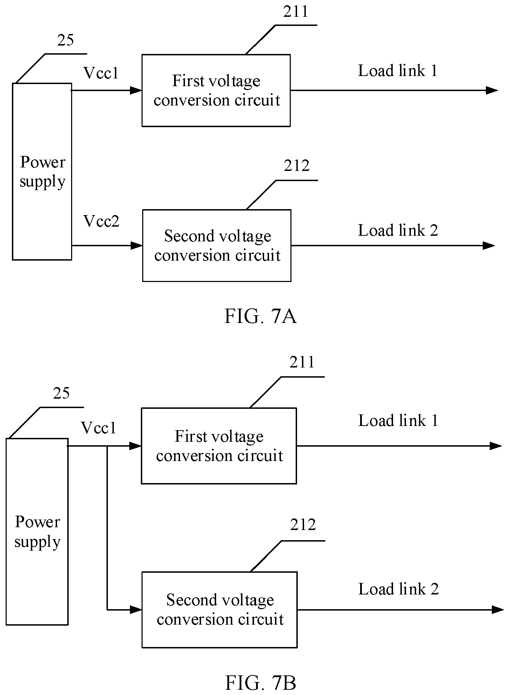

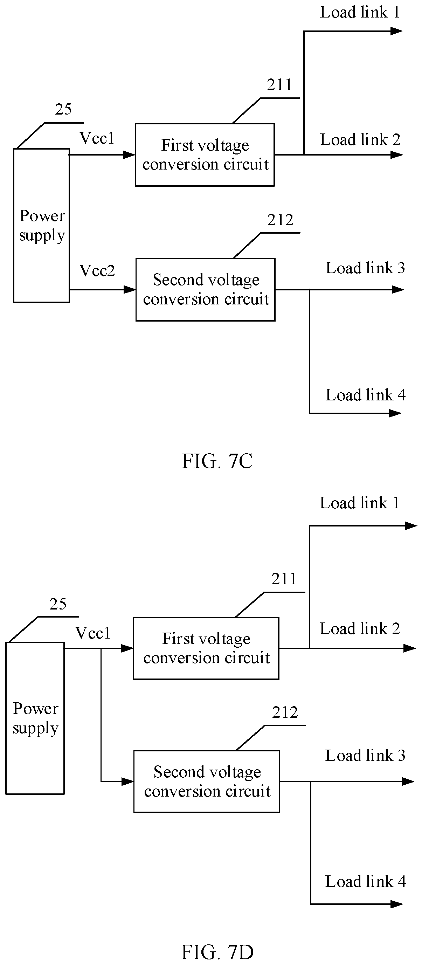

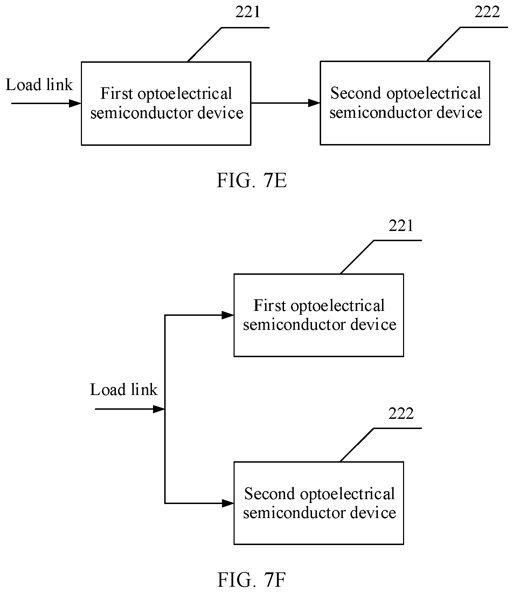

The power supply 25, the voltage conversion circuit 21, and the optoelectrical semiconductor device 22 may be coupled in a plurality of manners. The following describes the coupling manner between the power supply 25, the voltage conversion circuit 21, and the optoelectrical semiconductor device 22 with reference to FIG. 7 A, FIG. 7B, FIG. 7C, FIG. 7D, FIG. 7E, and FIG. 7F. For ease of description, for composition, functions, and coupling manners of other functional modules, refer to descriptions in other accompanying drawings.

As shown in FIG. 7A, the power supply 25 outputs two voltages Vcc1 and Vcc2, which are respectively output to a first voltage conversion circuit 211 and a second voltage conversion circuit 212. Vcc1 and Vcc2 may be the same or different. A bias voltage output by the first voltage conversion circuit 211 is controlled by the control signal Z output by the controller, to adjust an output optical power output by an optoelectrical semiconductor device in a load link 1. A bias voltage output by the second voltage conversion circuit 212 is controlled by the control signal Z output by the controller, to adjust an output optical power output by an optoelectrical semiconductor device in a load link 2.

As shown in FIG. 7B, the power supply 25 outputs a voltage Vcc1 to a first voltage conversion circuit 211 and a second voltage conversion circuit 212. A bias voltage output by the first voltage conversion circuit 211 is controlled by the control signal Z output by the controller, to adjust an output optical power output by an optoelectrical semiconductor device in a load link 1. A bias voltage output by the second voltage conversion circuit 212 is controlled by the control signal Z output by the controller, to adjust an output optical power output by an optoelectrical semiconductor device in a load link 2.

As shown in FIG. 7C, the power supply 25 outputs two voltages Vcc1 and Vcc2, which are respectively output to a first voltage conversion circuit and a second voltage conversion circuit 212. Vcc1 and Vcc2 may be the same or different. A load link 1 and a load link 2 are in parallel coupled to a voltage output end of the first voltage conversion circuit 211, and a bias voltage output by the first voltage conversion circuit 211 is controlled by the control signal Z output by the controller, to adjust output optical powers output by an optoelectrical semiconductor device in the load link 1 and an optoelectrical semiconductor device in the load link 2. A load link 3 and a load link 4 are in parallel coupled to the voltage output end of the first voltage conversion circuit 211, and a bias voltage output by the second voltage conversion circuit 212 is controlled by the control signal Z output by the controller, to adjust output optical powers output by an optoelectrical semiconductor device in the load link 3 and an optoelectrical semiconductor device in the load link 4.

As shown in FIG. 7D, the power supply 25 outputs a voltage Vcc1 to a first voltage conversion circuit 211 and a second voltage conversion circuit 212. A load link 1 and a load link 2 are in parallel coupled to a voltage output end of the first voltage conversion circuit 211, and a bias voltage output by the first voltage conversion circuit 211 is controlled by the control signal Z output by the controller, to adjust output optical powers output by an optoelectrical semiconductor device in the load link 1 and an optoelectrical semiconductor device in the load link 2. A load link 3 and a load link 4 are in parallel coupled to the voltage output end of the first voltage conversion circuit 211, and a bias voltage output by the second voltage conversion circuit 212 is controlled by the control signal Z output by the controller, to adjust output optical powers output by an optoelectrical semiconductor device in the load link 3 and the optoelectrical semiconductor device in the load link 2.

As shown in FIG. 7E, a plurality of optoelectrical semiconductor devices (for example, a first optoelectrical semiconductor device 221 and a second optoelectrical semiconductor device 222) may be in series connected to a load link; or as shown in FIG. 7F, a plurality of optoelectrical semiconductor devices (for example, a first optoelectrical semiconductor device 221 and a second optoelectrical semiconductor device 222) may be connected in parallel to a load link. That is, FIG. 7E and FIG. 7F may be freely combined with FIG. 7A to FIG. 7D. It should be noted that, in this case, each optoelectrical semiconductor device is paired with an independent optoelectrical detection circuit.

For FIG. 7E and FIG. 7F, the first optoelectrical semiconductor device 221 is paired with a first optoelectrical detection circuit, and is configured to: detect the output optical power output by the first optoelectrical semiconductor device 221, and output a first control signal to the controller 24. The second optoelectrical semiconductor device 222 is paired with a second optoelectrical detection circuit, and is configured to: detect the output optical power output by the second optoelectrical semiconductor device 222, and output a second control signal to the controller 24. The controller 24 may determine a control signal based on a first detection signal and a second detection signal, and send the control signal to the voltage conversion circuit 21. Because the first optoelectrical semiconductor device 221 and the second optoelectrical semiconductor device 222 are coupled to the voltage conversion circuit 21 through a load link. Therefore, bias voltages provided to the first optoelectrical semiconductor device 221 and the second optoelectrical semiconductor device 222 can be adjusted based on the control signal.

Regardless of whether the first optoelectrical semiconductor device 221 and the second optoelectrical semiconductor device 222 are connected in series or in parallel, if the first detection signal is less than the second detection signal, and the first detection signal is less than a first threshold, (in other words, the output optical power output by the optoelectrical semiconductor device is excessively low), the controller 24 determines the control signal based on the first detection signal, where the control signal may indicate the voltage conversion circuit 21 to increase the bias voltage, to increase the output optical powers output by the first optoelectrical semiconductor device 221 and the second optoelectrical semiconductor device 222. That is, if an output optical power output by the optoelectrical assembly needs to be increased, the control signal is determined based on a detection signal corresponding to a smaller one of output optical powers output by two optoelectrical semiconductor devices.

Regardless of whether the first optoelectrical semiconductor device 221 and the second optoelectrical semiconductor device 222 are connected in series or in parallel, if the first detection signal is less than the second detection signal, and the second detection signal is greater than a second threshold (in other words, the output optical power output by the optoelectrical semiconductor device is excessively high), the controller 24 determines the control signal based on the second detection signal, where the control signal may indicate the voltage conversion circuit 21 to decrease the bias voltage, to decrease the output optical powers output by the first optoelectrical semiconductor device 221 and the second optoelectrical semiconductor device 222. That is, if an output optical power output by the optoelectrical assembly needs to be decreased, the control signal is determined based on a detection signal corresponding to a larger one of output optical powers output by two optoelectrical semiconductor devices.

Various coupling manners between the power supply 25, the voltage conversion circuit 21, and the optoelectrical semiconductor device 22 provide more flexibility for a design of the optoelectrical assembly. This can further reduce a quantity of devices, reduce costs, and improve integration.

It should be noted that a person skilled in the art may perform various combinations with reference to FIG. 7A, FIG. 7B, FIG. 7C, FIG. 7D, FIG. 7E, and FIG. 7F, and all combinations may be considered as embodiments of this application, and fall within the protection scope of this application. In addition, various combination manners in FIG. 7A, FIG. 7B, FIG. 7C, FIG. 7D, FIG. 7E, and FIG. 7F require that all load links in a same voltage conversion circuit have good consistency, and all optoelectrical semiconductor devices in a same load link have good consistency. Otherwise, adjustment trends of two optoelectrical semiconductor devices are inconsistent or power oscillation is likely to occur. In addition, if the first threshold and the second threshold coexist, it is also required that the first threshold and the second threshold cannot be excessively close to each other. Otherwise, the adjustment trends of the two optoelectrical semiconductor devices are inconsistent or the power oscillation is likely to occur.

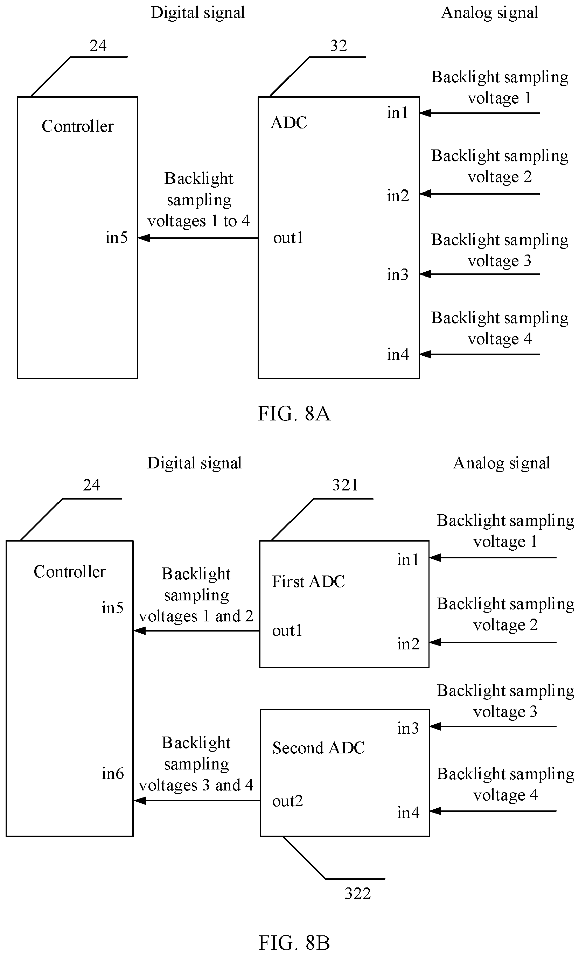

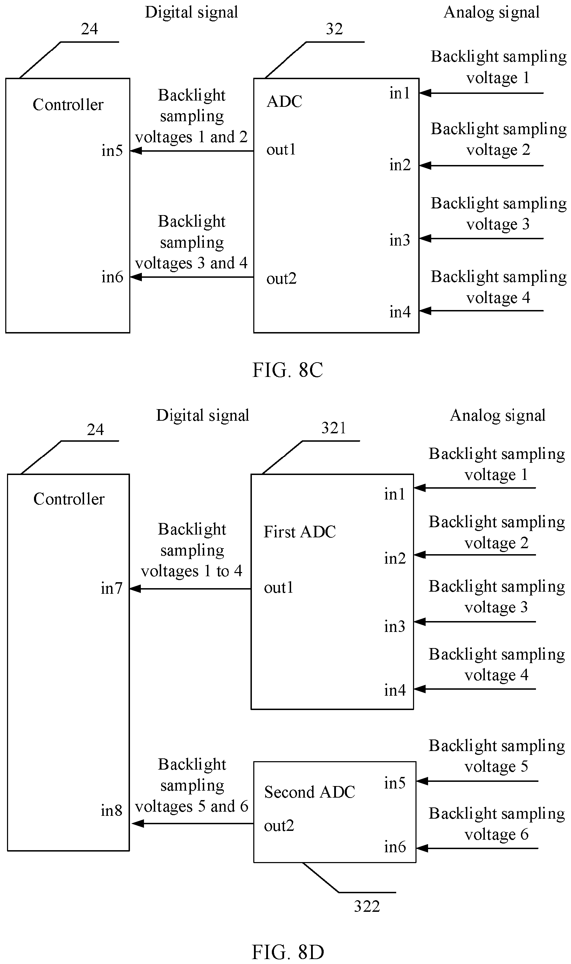

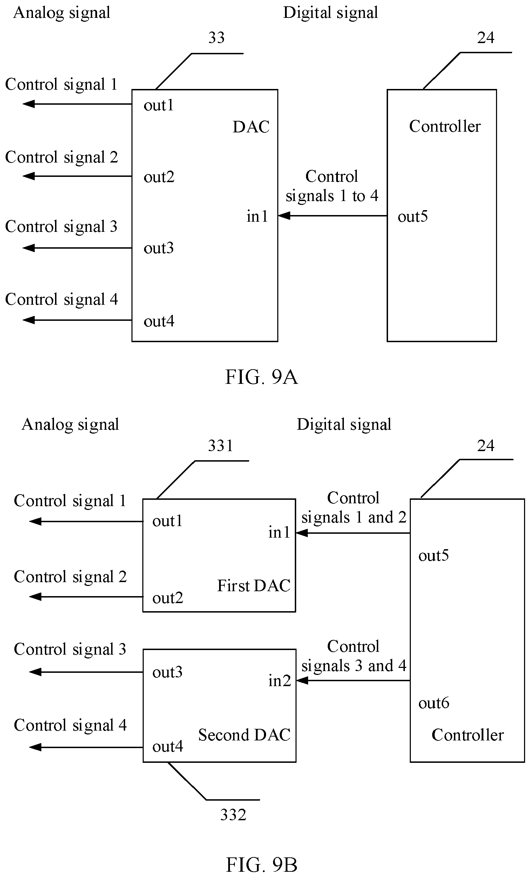

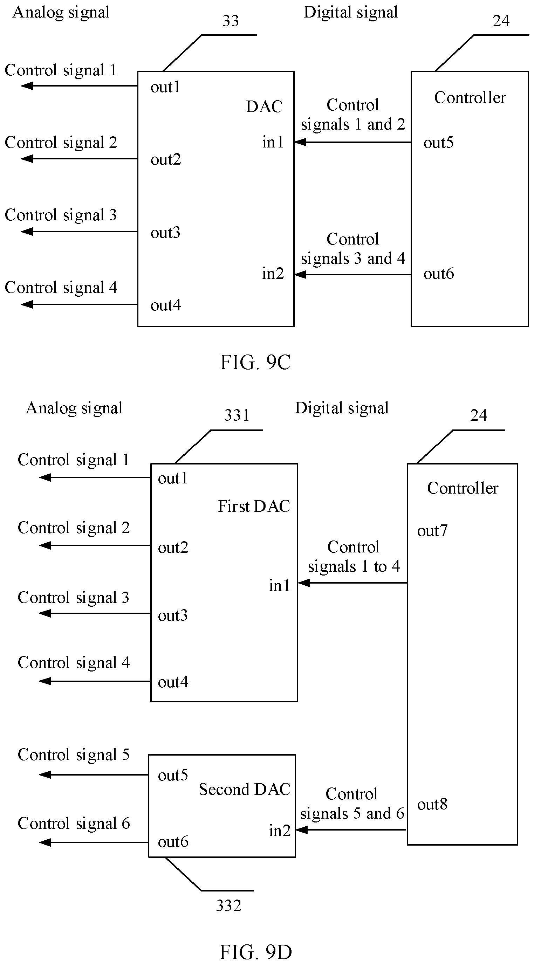

The ADC 32, the DAC 33, and the controller 24 may be coupled in a plurality of manners. The following describes a coupling manner between the ADC 32 and the controller 24 with reference to FIG. 8A, FIG. 8B, FIG. 8C, and FIG. 8D, and describes a coupling manner between the controller 24 and the DAC 33 with reference to FIG. 9A, FIG. 9B, FIG. 9C, and FIG. 9D. For ease of description, for composition, functions, and coupling manners of other functional modules, refer to descriptions in other accompanying drawings.

As shown in FIG. 8A, the ADC 32 includes four analog input ports (in1 to in4) and one digital output port (out1). The controller 24 includes one digital input port (in5), and the digital input port in5 of the controller 24 is coupled to the digital output port out1 of the ADC 32. The four analog input ports (in1 to in4) of the ADC 32 respectively receive four analog signals (a backlight sampling voltage 1 to a backlight sampling voltage 4) from the optoelectrical detection circuit. The ADC 32 separately performs analog-to-digital conversion on the four analog signals to obtain four digital signals, and outputs the four digital signals to the controller 24 through the digital output port out1 of the ADC 32 in a serial manner in a specific sequence. After receiving the four digital signals, the controller 24 parses the four digital signals in a specific sequence, to obtain values of the four backlight sampling voltages. The controller 24 may obtain one control signal based on each of the four backlight sampling voltages, and respectively send four control signals to corresponding voltage conversion circuits to adjust an output bias voltage.

As shown in FIG. 8B, a first ADC 321 includes two analog input ports (in1 and in2) and one digital output port (out1), and a second ADC 322 includes two analog input ports (in3 and in4) and one digital output port (out2). The controller 24 includes two digital input ports (in5 and in6). The digital input port in5 of the controller 24 is coupled to the digital output port out1 of the first ADC 321, and the digital input port in6 of the controller 24 is coupled to the digital output port out2 of the second ADC 322. The two analog input ports (in1 and in2) of the first ADC 321 respectively receive two analog signals (a backlight sampling voltage 1 and a backlight sampling voltage 2) from the optoelectrical detection circuit. The firstADC 321 separately performs analog-to-digital conversion on the two analog signals to obtain two digital signals, and outputs the two digital signals to the controller 24 through the digital output port out1 of the first ADC 321 in a serial manner in a specific sequence. After receiving the two digital signals, the controller 24 parses the two digital signals in a specific sequence, to obtain values of the two backlight sampling voltages. The two analog input ports (in3 and in4) of the second ADC 322 respectively receive two analog signals (backlight sampling voltage 3 and backlight sampling voltage 4) from the optoelectrical detection circuit. The second ADC 322 separately performs analog-to-digital conversion on the two analog signals to obtain two digital signals, and outputs the two digital signals to the controller 24 through the digital output port out2 of the second ADC 322 in a serial manner in a specific sequence. After receiving the two digital signals, the controller 24 parses the two digital signals in a specific sequence, to obtain values of the two backlight sampling voltages. The controller 24 may obtain one control signal based on each of the four backlight sampling voltages, and respectively send four control signals to corresponding voltage conversion circuits to adjust an output bias voltage.

As shown in FIG. 8C, the ADC 32 includes four analog input ports (in1 to in4) and one digital output port (out1). The controller 24 includes two digital input ports (in5 and in6). The digital input port in5 of the controller 24 is coupled to the digital output port out1 of the ADC 32, and the digital input port in6 of the controller 24 is coupled to the digital output port out2 of the ADC 32. The two analog input ports (in1 and in2) of the ADC 32 respectively receive two analog signals (a backlight sampling voltage 1 and a backlight sampling voltage 2) from the optoelectrical detection circuit. The ADC 32 separately performs analog-to-digital conversion on the two analog signals to obtain two digital signals, and outputs the two digital signals to the controller 24 through the digital output port out1 of the ADC 32 in a serial manner in a specific sequence. After receiving the two digital signals, the controller 24 parses the two digital signals in a specific sequence, to obtain values of the two backlight sampling voltages. The two analog input ports (in3 and in4) of the ADC 32 respectively receive two analog signals (a backlight sampling voltage 3 and a backlight sampling voltage 4) from the optoelectrical detection circuit. The ADC 32 separately performs analog-to-digital conversion on the two analog signals to obtain two digital signals, and outputs the two digital signals to the controller 24 through the digital output port out2 of the ADC 32 in a serial manner in a specific sequence. After receiving the two digital signals, the controller 24 parses the two digital signals in a specific sequence, to obtain values of the two backlight sampling voltages. The controller 24 may obtain one control signal based on each of the four backlight sampling voltages, and respectively send four control signals to corresponding voltage conversion circuits to adjust an output bias voltage. More usually, a sum of total quantities of digital signals output from the output port out1 and the output port out2 of the ADC 32 is 4, but quantities of digital signals respectively output from the output port out1 and the output port out2 and corresponding relationships between the quantities and the corresponding backlight sampling voltage 1 to backlight sampling voltage 4 are not limited.

As shown in FIG. 8D, a first ADC 321 includes four analog input ports (in1 to in4) and one digital output port (out1), and a second ADC 322 includes two analog input ports (in5 and in6) and one digital output port (out2). The controller 24 includes two digital input ports (in7 and in8). The digital input port in7 of the controller 24 is coupled to the digital output port out1 of the first ADC 321, and the digital input port in8 of the controller 24 is coupled to the digital output port out2 of the second ADC 322. The four analog input ports (in1 to in4) of the first ADC 321 respectively receive four analog signals (a backlight sampling voltage 1 to a backlight sampling voltage 4) from the optoelectrical detection circuit. The firstADC 321 separately performs analog-to-digital conversion on the four analog signals to obtain four digital signals, and outputs the four digital signals to the controller 24 through the digital output port out1 of the first ADC 321 in a serial manner in a specific sequence. After receiving the four digital signals, the controller 24 parses the four digital signals in a specific sequence, to obtain values of the four backlight sampling voltages. The two analog input ports (in5 and in6) of the second ADC 322 respectively receive two analog signals (a backlight sampling voltage 5 and a backlight sampling voltage 6) from the optoelectrical detection circuit. The second ADC 322 separately performs analog-to-digital conversion on the two analog signals to obtain two digital signals, and outputs the two digital signals to the controller 24 through the digital output port out2 of the second ADC 322 in a serial manner in a specific sequence. After receiving the two digital signals, the controller 24 parses the two digital signals in a specific sequence, to obtain values of the two backlight sampling voltages.

As shown in FIG. 9A, the DAC 33 includes four analog output ports (out1 to out4) and one digital input port (in1). The controller 24 includes one digital output port (out5). The digital output port out5 of the controller 24 is coupled to the digital input port in1 of the DAC 33. The controller 24 outputs four control signals (a control signal 1 to a control signal 4) to the DAC 33 through the digital output port out5 of the controller 24 in a serial manner in a specific sequence. After receiving four digital signals, the DAC 33 parses the four digital signals in a specific sequence to obtain four control signals, separately performs analog-to-digital conversion on the four control signals to obtain four analog signals, and separately outputs the four analog signals through the four analog output ports (out1 to out4) of the DAC 33.

As shown in FIG. 9B, a first DAC 331 includes two analog output ports (out1 and out2) and one digital input port (in1). A second DAC 332 includes two analog output ports (out3 and out4) and one digital input port (in2). The controller 24 includes two digital output ports (out5 and out6). The digital output port out5 of the controller 24 is coupled to the digital input port in1 of the first DAC 331, and the digital output port out6 of the controller 24 is coupled to the digital input port in2 of the second DAC 332. The controller 24 outputs two control signals (a control signal 1 and a control signal 2) to the first DAC 331 through the digital output port out5 of the controller 24 in a serial manner in a specific sequence. After receiving two digital signals, the first DAC 331 parses the two digital signals in a specific sequence to obtain two control signals, separately performs analog-to-digital conversion on the two control signals to obtain two analog signals, and separately outputs the two analog signals through the two analog output ports (out1 and out2) of the first DAC 33. The controller 24 outputs two control signals (a control signal 3 and a control signal 4) to the second DAC 332 through the digital output port out6 of the controller 24 in a serial manner in a specific sequence. After receiving two digital signals, the second DAC 332 parses the two digital signals in a specific sequence to obtain two control signals, separately performs analog-to-digital conversion on the two control signals to obtain two analog signals, and separately outputs the two analog signals through the two analog output ports (out3 and out4) of the second DAC 332.

As shown in FIG. 9C, the DAC 33 includes four analog output ports (out1 to out4) and two digital input ports (in1 and in2). The controller 24 includes two digital output ports (out5 and out6). The digital output port out5 of the controller 24 is coupled to the digital input port in1 of the DAC 33, and the digital output port out6 of the controller 24 is coupled to the digital input port in2 of the DAC 33. The controller 24 outputs two control signals (a control signal 1 and a control signal 2) to the DAC 33 through the digital output port out5 of the controller 24 in a serial manner in a specific sequence. After receiving two digital signals, the DAC 33 parses the two digital signals in a specific sequence to obtain two control signals, separately performs analog-to-digital conversion on the two control signals to obtain two analog signals, and separately outputs the two analog signals through two analog output ports (out1 and out2) of the DAC 33. The controller 24 outputs two control signals (a control signal 3 and a control signal 4) to the DAC 33 through the digital output port out6 of the controller 24 in a serial manner in a specific sequence. After receiving two digital signals, the DAC 33 parses the two digital signals in a specific sequence to obtain two control signals, separately performs analog-to-digital conversion on the two control signals to obtain two analog signals, and separately outputs the two analog signals through two analog output ports (out3 and out4) of the DAC 33. More usually, a sum of total quantities of digital signals input from the input port in1 and the input port in2 of the DAC 33 is 4, but quantities of digital signals respectively input from the input port in1 and the input port in2 and corresponding relationships between the quantities and the corresponding control signal 1 to control signal 4 are not limited.

As shown in FIG. 9D, a first DAC 331 includes four analog output ports (out1 to out4) and one digital input port (in1). A second DAC 332 includes two analog output ports (out5 and out6) and one digital input port (in2). The controller 24 includes two digital output ports (out7 and out8). The digital output port out7 of the controller 24 is coupled to the digital input port in1 of the first DAC 331, and the digital output port out8 of the controller 24 is coupled to the digital input port in2 of the second DAC 332. The controller 24 outputs four control signals (a control signal 1 to a control signal 4) to the first DAC 331 through the digital output port out7 of the controller 24 in a serial manner in a specific sequence. After receiving four digital signals, the first DAC 331 parses the four digital signals in a specific sequence to obtain four control signals, separately performs analog-to-digital conversion on the four control signals to obtain four analog signals, and separately outputs the four analog signals through the four analog output ports (out1 to out4) of the first DAC 331. The controller 24 outputs two control signals (a control signal 5 and a control signal 6) to the second DAC 332 through the digital output port out8 of the controller 24 in a serial manner in a specific sequence. After receiving two digital signals, the second DAC 332 parses the two digital signals in a specific sequence to obtain two control signals, separately performs analog-to-digital conversion on the two control signals to obtain two analog signals, and separately outputs the two analog signals through the two analog output ports (out5 and out6) of the second DAC 332.

The coupling manners shown in FIG. 8A, FIG. 8B, FIG. 8C, FIG. 8D, FIG. 9A, FIG. 9B, FIG. 9C, and FIG. 9D improve design flexibility of the optoelectrical assembly, and can further reduce a resource requirement for an analog-to-digital conversion interface and a digital-to-analog conversion interface, reduce quantities of ADCs and DACs, reduce costs, improve integration, and facilitate miniaturization of the optoelectrical assembly. For example, when the ADC converts two analog signals into one digital signal, 50% of ADCs can be reduced. When the ADC can convert more analog signals into one digital signal, more ADCs can be reduced. When the DAC converts two digital signals into one analog signal, 50% of DACs can be reduced. When the DAC can convert more digital signals into one analog signal, more DACs can be reduced.

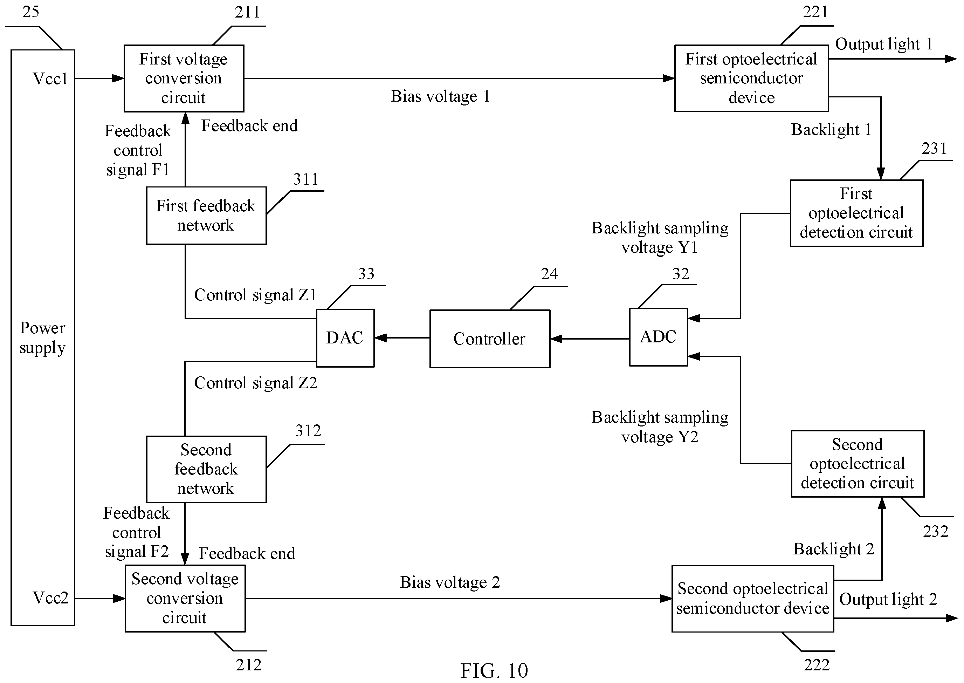

The following describes a specific coupling manner between the ADC 32, the DAC 33, and the controller 24 with reference to FIG. 10.

As shown in FIG. 10, the power supply 25 provides power supply voltages Vcc1 and Vcc2 to the entire optoelectrical assembly. The first voltage conversion circuit 211 converts the voltage Vcc1 into a bias voltage 1 and provides the bias voltage 1 to the first optoelectrical semiconductor device 221. The bias voltage 1 output by the first voltage conversion circuit 211 may be adjusted based on a control signal Z1 output by the controller 24. The second voltage conversion circuit 212 converts the voltage Vcc2 into a bias voltage 2 and provides the bias voltage 2 to the second optoelectrical semiconductor device 222. The bias voltage 2 output by the second voltage conversion circuit 212 may be adjusted based on a control signal Z2 output by the controller 24. At least one of the first voltage conversion circuit 211 and the second voltage conversion circuit 212 may be a DC-DC conversion circuit. For example, 0.9*Vcc1>bias voltage 1>1.0 V, and Vcc1>1.3 V, 0.9*Vcc2>bias voltage 2>1.0 V, and Vcc2>1.3 V

It should be noted that this embodiment of this application is described by using an example in which two voltage conversion circuits respectively provide bias voltages to two optoelectrical semiconductor devices, but this is not intended to be limited thereto. For example, more voltage conversion circuits may respectively provide bias voltages to more optoelectrical semiconductor devices.

Output light of the first optoelectrical semiconductor device 221 includes two parts. The first part is output light 1, and the second part (backlight 1) is output to a first optoelectrical detection circuit 231 for detecting an optical power of the first optoelectrical semiconductor device 221. Output light of the second optoelectrical semiconductor device 222 includes two parts. The first part is output light 2, and the second part (backlight 2) is output to a second optoelectrical detection circuit 232 for detecting an optical power of the second optoelectrical semiconductor device 222. Resistance values of the first optoelectrical semiconductor device 221 and the second optoelectrical semiconductor device 222 within the range of the target optical power both are less than or equal to 60 Q, and differential resistance values Rdiff of the first optoelectrical semiconductor device and the second optoelectrical semiconductor device within the range of the target optical power satisfy $0.1 \ \Omega \le Rdiff \le 50 \ \Omega$.

The first optoelectrical detection circuit 231 is configured to detect an output optical power output by the first optoelectrical semiconductor device 221, and the second optoelectrical detection circuit 232 is configured to detect an output optical power output by the second optoelectrical semiconductor device 222.

The ADC 32 includes two analog input ports, which respectively receive a backlight sampling voltage Y1 (analog signal) from the first optoelectrical detection circuit 231 and a backlight sampling voltage Y2 (analog signal) from the second optoelectrical detection circuit 232. The ADC 32 converts the backlight sampling voltage Y1 (analog signal) into a backlight sampling voltage Y1 (digital signal), and converts the backlight sampling voltage Y2 (analog signal) into a backlight sampling voltage Y2 (digital signal), and outputs the two digital signals to the controller 24 through the digital output port in a serial manner in a specific sequence. The ADC converts two signals into one signal. This can reduce 50% of ADC resources.

The controller 24 obtains the corresponding backlight sampling voltage Y1 (digital) and backlight sampling voltage Y2 (digital signal) through parsing in a specific sequence according to a rule of outputting a backlight sampling voltage (digital signal) by the ADC 32. The controller 24 generates a control signal Z1 (digital signal) based on the backlight sampling voltage Y1 (digital signal), generates a control signal Z2 (digital signal) based on the backlight sampling voltage Y2 (digital signal), and outputs the two control signals to the DAC 33 through the digital output port in a specific sequence.

The DAC 33 obtains a control signal Z1 (digital signal) and a control signal Z2 (digital signal) in a specific sequence according to a corresponding rule of outputting a control signal by the controller 24. The DAC 33 performs digital-to-analog conversion on the control signal Z1 (digital signal) to obtain a control signal Z1 (analog signal), and outputs the control signal Z1 (analog signal) to a first feedback network 311 through an analog output port. The DAC 33 performs digital-to-analog conversion on the control signal Z2 (digital signal) to obtain a control signal Z2 (analog signal), and outputs the control signal Z2 (analog signal) to a second feedback network 312 through an analog output port. The DAC converts one signal into two signals. This can reduce 50% of DAC resources.

The first feedback network 311 is configured to: increase or decrease a voltage range of the control signal Z1 to obtain a feedback control signal F1, and output the feedback control signal F1 to a feedback end of the first voltage conversion circuit 211, to meet a requirement for a range of a signal input by the first voltage conversion circuit 211, and equivalently improve precision of the control signal Z1. The second feedback network 312 is configured to: increase or decrease a voltage range of the control signal Z2 to obtain a feedback control signal F2, and output the feedback control signal F2 to a feedback end of the second voltage conversion circuit 212, to meet a requirement for a range of a signal input by the second voltage conversion circuit 212, and equivalently improve precision of the control signal Z2. The bias voltage 1 output by the first voltage conversion circuit 211 may be adjusted based on the feedback control signal F1, and the bias voltage 2 output by the second voltage conversion circuit 212 may be adjusted based on the feedback control signal F2.

The following describes how the controller 24 obtains the load link information X.

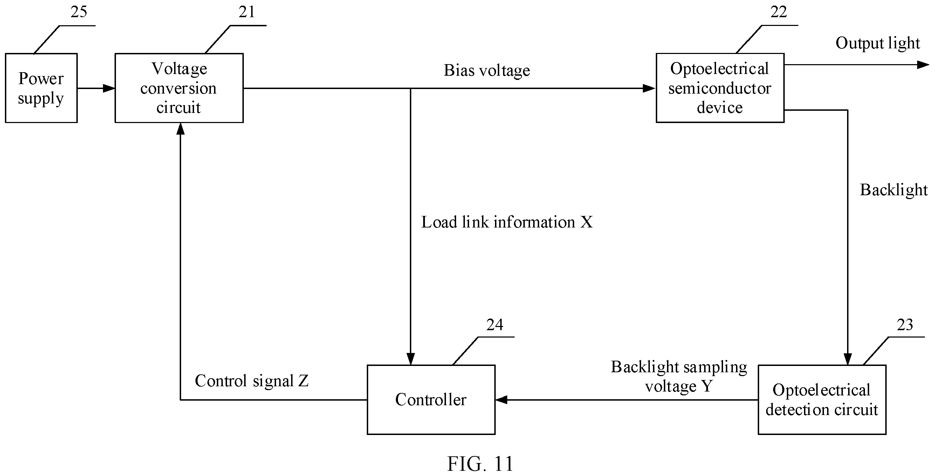

In a possible implementation, as shown in FIG. 11, based on FIG. 2, when the controller 24 has an analog-to-digital conversion interface (in other words, an analog signal may be directly input) and a digital-to-analog conversion interface (in other words, an analog signal may be directly output), or when resources of the analog-to-digital conversion interface and the digital-to-analog conversion interface of the controller 24 are sufficient, the controller 24 may directly obtain the load link information X from the bias voltage output end of the voltage conversion circuit 21.

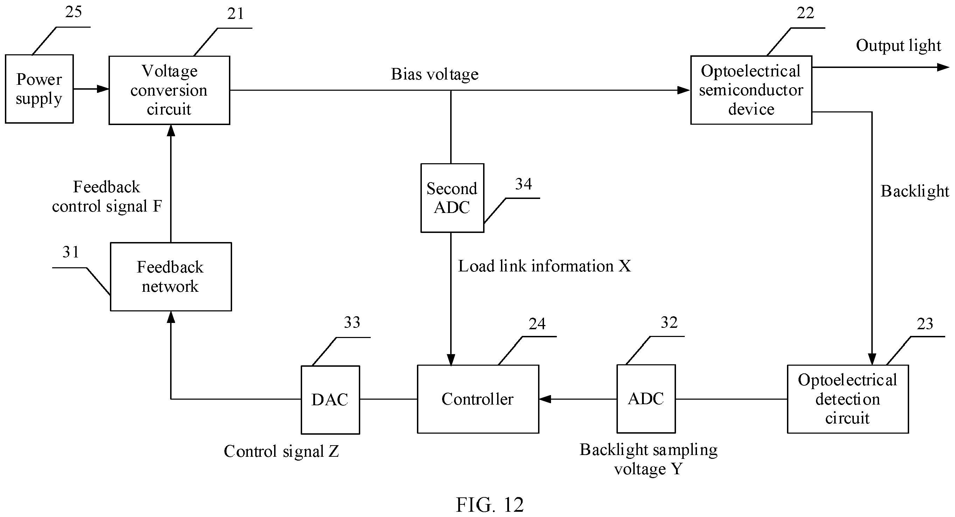

In another possible implementation, as shown in FIG. 12, based on FIG. 3, when the controller 24 does not have an analog-to-digital conversion interface or a digital-to-analog conversion interface, or when resources of the analog-to-digital conversion interface and the digital-to-analog conversion interface of the controller 24 are insufficient, the optoelectrical assembly may further include a second ADC 34. An analog input port of the second ADC 34 is coupled to the bias voltage output end of the voltage conversion circuit 21, and a digital output port of the second ADC 34 is coupled to an input end of the controller 24. The controller 24 may obtain the load link information X from the bias voltage output end of the voltage conversion circuit 21 by using the second ADC 34. When the controller 24 has an analog-to-digital conversion interface (in other words, an analog signal may be directly input), or when the analog-to-digital conversion interface of the controller 24 is sufficient, a second ADC 34 may be an analog-to-digital conversion interface of the controller 24.

In addition, the second ADC 34 and the ADC 32 may be an ADC with two analog inputs and one digital output, and two analog input ports of the ADC may be respectively coupled to the bias voltage output end of the voltage conversion circuit 21 and an output end of the optoelectrical detection circuit 23. The ADC may output the load link information X and the backlight sampling voltage Y to the controller 24 in a serial manner in a specific sequence, and the controller 24 may obtain the load link information X and the backlight sampling voltage Y through parsing in a specific sequence. This can reduce a quantity of ADCs, reduce costs, improve integration, and facilitate miniaturization of the optoelectrical assembly.

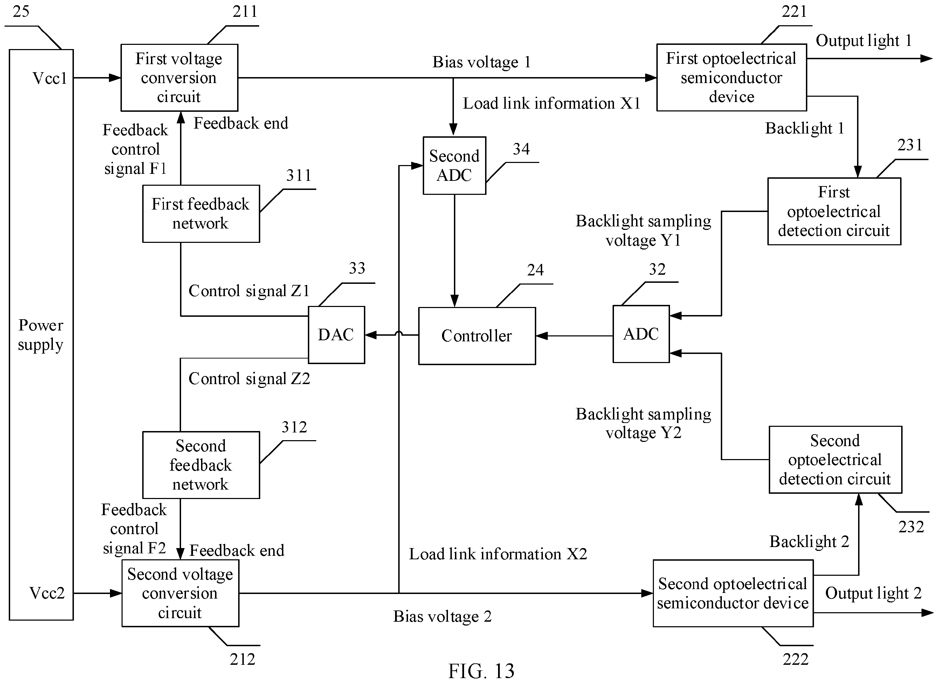

In still another possible implementation, as shown in FIG. 13, based on FIG. 10, when the controller 24 does not have an analog-to-digital conversion interface or a digital-to-analog conversion interface, or when resources of the analog-to-digital conversion interface and the digital-to-analog conversion interface of the controller 24 are insufficient, the optoelectrical assembly may further include a second ADC 34. Two analog input ports of the second ADC 34 are respectively coupled to an output end of the first voltage conversion circuit 211 and an output end of the second voltage conversion circuit 212, and a digital output port of the second ADC 34 is coupled to the controller 24. The controller 24 may obtain load link information X1 from the output end of the first voltage conversion circuit 211 by using the second ADC 34, and obtain load link information X2 from the output end of the second voltage conversion circuit 212 by using the second ADC 34. The second ADC 34 separately performs analog-to-digital conversion on the load link information X1 and the load link information X2 to obtain two digital signals, and outputs the two digital signals to the controller 24 through the digital output port of the second ADC 34 in a serial manner in a specific sequence. The controller 24 may obtain the load link information X1 and the load link information X2 through parsing in a specific sequence. The controller 24 may determine a control signal Z1 based on the load link information X1 and the backlight sampling voltage Y1, and output the control signal Z1 to the first voltage conversion circuit 211. The controller 24 may determine a control signal Z2 based on the load link information X2 and the backlight sampling voltage Y2, and output the control signal Z2 to the second voltage conversion circuit 212. When the controller 24 has an analog-to-digital conversion interface (in other words, an analog signal may be directly input), or when the analog-to-digital conversion interface of the controller 24 is sufficient, the second ADC 34 may be an analog-to-digital conversion interface of the controller 24.

In addition, the second ADC 34 and the ADC 32 may be an ADC with four analog inputs and one digital output. The four analog input ports of the ADC may be respectively coupled to an output end of the first voltage conversion circuit 211, an output end of the second voltage conversion circuit 212, an output end of the first optoelectrical detection circuit 231, and an output end of the second optoelectrical detection circuit 232. The ADC may output the load link information X1, the load link information X2, the backlight sampling voltage Y1, and the backlight sampling voltage Y2 to the controller 24 through the digital output port of the second ADC 34 in a specific sequence. The controller 24 may obtain the load link information X1, the load link information X2, the backlight sampling voltage Y1, and the backlight sampling voltage Y2 through parsing in a specific sequence. This can reduce a quantity of ADCs, reduce costs, improve integration, and facilitate miniaturization of the optoelectrical assembly.

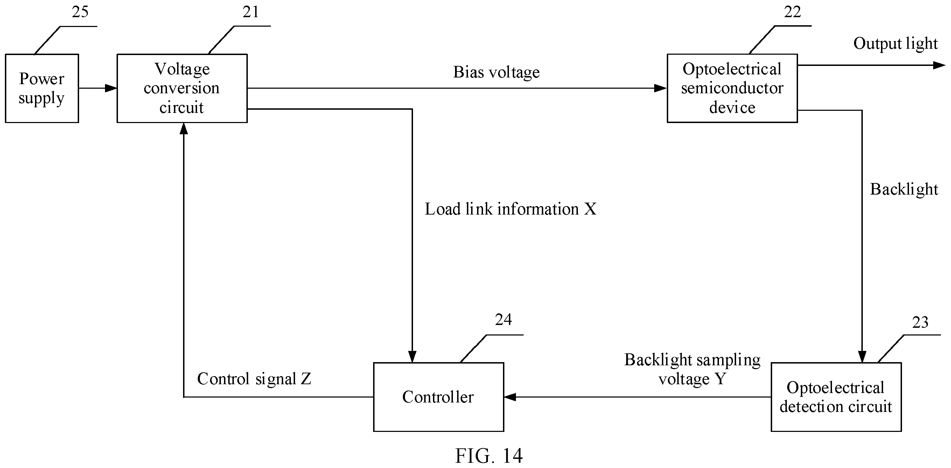

In still another possible implementation, as shown in FIG. 14, based on FIG. 2, the voltage conversion circuit 21 further has an information output end, the information output end is coupled to an information input end of the controller 24, and the information output end is configured to output the load link information X to the controller 24.

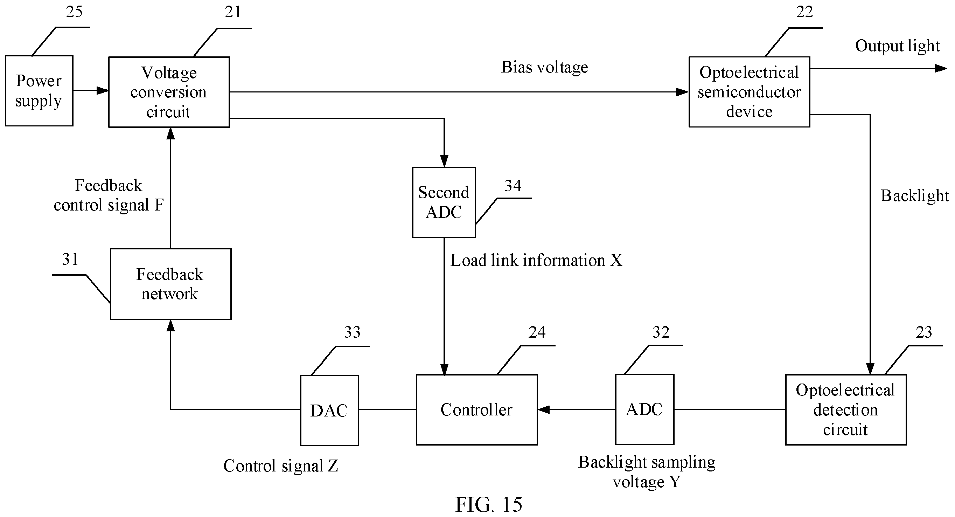

In still another possible implementation, as shown in FIG. 15, based on FIG. 3, the voltage conversion circuit 21 further has an information output end, which is configured to output the load link information X, and the load link information X is an analog signal. When the controller 24 does not have an analog-to-digital conversion interface or a digital-to-analog conversion interface, or when resources of the analog-to-digital conversion interface and digital-to-analog conversion interface of the controller 24 are insufficient, the optoelectrical assembly may further include a second ADC 34. An analog input port of the second ADC 34 is coupled to the information output end of the voltage conversion circuit 21, and a digital output port of the second ADC 34 is coupled to an input end of the controller 24. The second ADC 34 performs analog-to-digital conversion on the load link information X to obtain a digital signal, and outputs the digital signal to the controller 24 through the digital output port of the second ADC 34.

In addition, the second ADC 34 and the ADC 32 may be an ADC with two analog inputs and one digital output, and two analog input ports of the ADC may be respectively coupled to the information output end of the voltage conversion circuit 21 and an output end of the optoelectrical detection circuit 23. The ADC may output the load link information X and the backlight sampling voltage Y to the controller 24 in a serial manner in a specific sequence, and the controller 24 may obtain the load link information X and the backlight sampling voltage Y through parsing in a specific sequence. This can reduce a quantity of ADCs, reduce costs, improve integration, and facilitate miniaturization of the optoelectrical assembly.

In addition, the optoelectrical assembly may further include a temperature control drive circuit and a temperature control circuit. The temperature control drive circuit is configured to supply power to the temperature control circuit. The temperature control circuit is configured to perform temperature control (for example, perform cooling or heating) on the optoelectrical semiconductor device 22, so that the optoelectrical semiconductor device 22 operates at preset operating temperature, to increase output optical power or prolong service life of the optoelectrical semiconductor device 22. For example, the temperature control circuit may be a thermoelectric cooler (thermoelectric cooler, TEC).

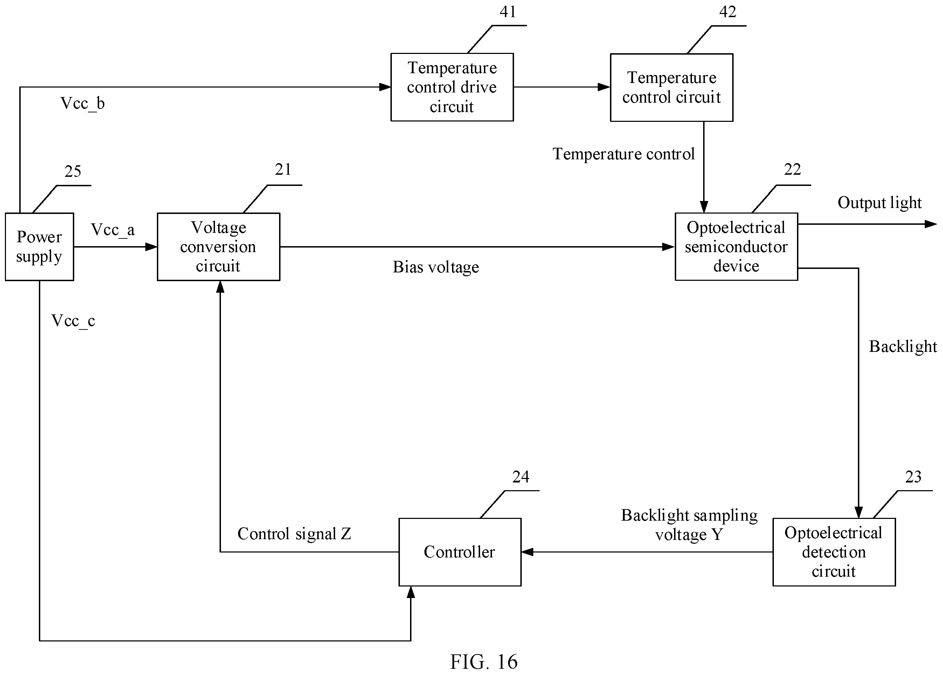

In a possible implementation, as shown in FIG. 16, based on FIG. 2, the optoelectrical assembly may further include a temperature control drive circuit 41 and a temperature control circuit 42. The power supply 25 is configured to supply power to the entire optoelectrical assembly, and the power supply 25 may have at least three voltage output ends, to provide a power supply voltage Vcc_a to the voltage conversion circuit 21, provide a power supply voltage Vcc_b to the temperature control drive circuit 41, and provide a power supply voltage Vcc_c to the controller 24. For example, the power supply 25 is located outside the entire optoelectrical assembly, and provides three power interfaces Vcc_a, Vcc_b, and Vcc_c to the optoelectrical assembly. The power supply voltage Vcc_a, the power supply voltage Vcc_b, and the power supply voltage Vcc_c may be the same or different, and a value of the power supply voltage may be determined based on a current characteristic or a voltage characteristic of a device coupled to the power supply 25. In addition, the power supply voltage Vcc_c may also be used to supply power to other devices such as an ADC and a DAC.

In addition, a value of the power supply voltage Vcc_a may be optimized and set based on an input-output voltage change efficiency curve of the voltage conversion circuit 21, to improve voltage conversion efficiency of the voltage conversion circuit 21 as much as possible. A value of the power supply voltage Vcc_b may be optimized and set based on voltages, currents, cooling capacities, heating capacities, cooling power consumption, heating power consumption, and the like of the temperature control drive circuit 41 and the temperature control circuit 42, to improve power supply energy efficiency of the temperature control circuit 42. A value of the power supply voltage Vcc_c may be optimized and set based on a voltage, a current, and power consumption of devices such as the controller 24, the ADC, and the DAC, to ensure normal operation of the device and improve system stability.

The power supply voltage Vcc_a may range from 1.8 V to 18 V For example, the power supply voltage Vcc_a may be 3.3 V, 5 V, 12 V, or the like. Deviation precision of the power supply voltage Vcc_a may be less than or equal to 20%. Further, the deviation precision of the power supply voltage Vcc_a may be less than or equal to 10%. Still further, the deviation precision of the power supply voltage may be less than or equal to 5%.

The power supply voltage Vcc_b may range from 2 V to 18 V For example, the power supply voltage Vcc_b may be 3.3 V, 5 V, 12 V, or the like. Deviation precision of the power supply voltage Vcc_b may be less than or equal to 20%. Further, the deviation precision of the power supply voltage Vcc_b may be less than or equal to 10%. Still further, the deviation precision of the power supply voltage may be less than or equal to 5%.

The power supply voltage Vcc_c may range from 1.5 V to 6 V For example, the power supply voltage Vcc_c may range from 1.8 V to 3.6 V Further, the power supply voltage Vcc_c may be 3.3 V Deviation precision of the power supply voltage Vcc_c may be less than or equal to 20%. Further, the deviation precision of the power supply voltage Vcc_c may be less than or equal to 10%. Still further, the deviation precision of the power supply voltage may be less than or equal to 5%.

A voltage ripple obtained by filtering processing of the bias voltage output by the voltage conversion circuit 21 is less than or equal to 50 mW. Further, the voltage ripple is less than or equal to 40 mV Further, the voltage ripple is less than or equal to 30 mV. Further, the voltage ripple is less than or equal to 20 mV. Further, the voltage ripple is less than or equal to 10 mV. Still further, the voltage ripple is less than or equal to 5 mV. A smaller voltage ripple indicates a smaller current change of the optoelectrical semiconductor device caused by the voltage ripple, and smaller impact on the target optical power.

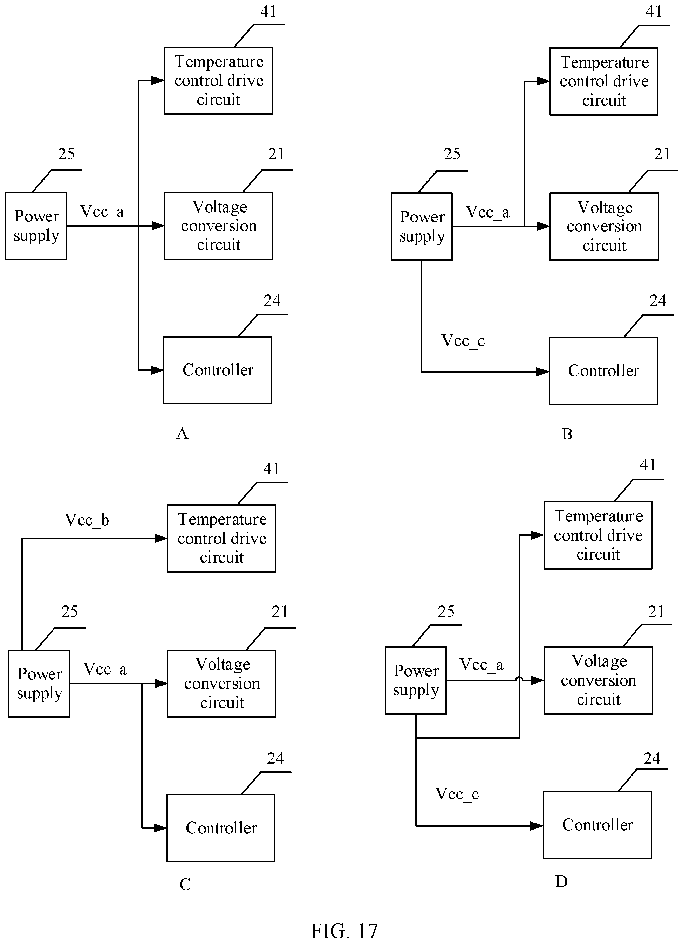

The following describes a coupling manner between the power supply 25, the voltage conversion circuit 21, the temperature control drive circuit 41, and the controller 24 with reference to FIG. 17. For ease of description, for composition, functions, and coupling manners of other functional modules, refer to descriptions in other accompanying drawings.

In a possible implementation, as shown in A in FIG. 17, the power supply 25 is configured to supply power to the entire optoelectrical assembly, and the power supply 25 may have at least one voltage output end, to provide a power supply voltage Vcc_a to the voltage conversion circuit 21, the temperature control drive circuit 41, and the controller 24. A value of the power supply voltage Vcc_a may be determined based on a current characteristic or a voltage characteristic of a device coupled to the power supply 25. In addition, the power supply voltage Vcc_a may also be used to supply power to other devices such as an ADC and a DAC.

The power supply voltage Vcc_a may range from 1.8 V to 18 V For example, the power supply voltage Vcc_a may range from 2 V to 6 V Further, the power supply voltage Vcc_a may range from 2 V to 3.6 V Further, the power supply voltage Vcc_a may be 3.3 V Deviation precision of the power supply voltage Vcc_a may be less than or equal to 20%. Further, the deviation precision of the power supply voltage Vcc_a may be less than or equal to 10%. Still further, the deviation precision of the power supply voltage may be less than or equal to 5%.

In another possible implementation, as shown in B in FIG. 17, the power supply 25 is configured to supply power to the entire optoelectrical assembly, and the power supply 25 may have at least two voltage output ends, to provide a power supply voltage Vcc_a to the voltage conversion circuit 21 and the temperature control drive circuit 41, and provide a power supply voltage Vcc_c to the controller 24. The power supply voltage Vcc_a and the power supply voltage Vcc_c may be the same or different, and a value of the power supply voltage may be determined based on a current characteristic or a voltage characteristic of a device coupled to the power supply 25. In addition, the power supply voltage Vcc_c may also be used to supply power to other devices such as an ADC and a DAC.

The power supply voltage Vcc_a may range from 1.8 V to 18 V For example, the power supply voltage Vcc_a may be 3.3 V, 5 V, 12 V, or the like. Deviation precision of the power supply voltage Vcc_a may be less than or equal to 20%. Further, the deviation precision of the power supply voltage Vcc_a may be less than or equal to 10%. Still further, the deviation precision of the power supply voltage may be less than or equal to 5%.

The power supply voltage Vcc_c may range from 1.5 V to 6 V For example, the power supply voltage Vcc_c may range from 1.8 V to 3.6 V Further, the power supply voltage Vcc_c may be 3.3 V Deviation precision of the power supply voltage Vcc_c may be less than or equal to 20%. Further, the deviation precision of the power supply voltage Vcc_c may be less than or equal to 10%. Still further, the deviation precision of the power supply voltage may be less than or equal to 5%.

In still another possible implementation, as shown in C in FIG. 17, the power supply 25 is configured to supply power to the entire optoelectrical assembly, and the power supply 25 may have at least two voltage output ends, to provide a power supply voltage Vcc_a to the voltage conversion circuit 21 and the controller 24, and provide a power supply voltage Vcc_b to the temperature control drive circuit 41. The power supply voltage Vcc_a and the power supply voltage Vcc_b may be the same or different, and a value of the power supply voltage may be determined based on a current characteristic or a voltage characteristic of a device coupled to the power supply 25. In addition, the power supply voltage Vcc_a may also be used to supply power to other devices such as an ADC and a DAC.

The power supply voltage Vcc_a may range from 1.8 V to 18 V For example, the power supply voltage Vcc_a may be 3.3 V, 5 V, 12 V, or the like. Deviation precision of the power supply voltage Vcc_a may be less than or equal to 20%. Further, the deviation precision of the power supply voltage Vcc_a may be less than or equal to 10%. Still further, the deviation precision of the power supply voltage may be less than or equal to 5%.

The power supply voltage Vcc_b may range from 2 V to 18 V For example, the power supply voltage Vcc_b may be 3.3 V, 5 V, 12 V, or the like. Deviation precision of the power supply voltage Vcc_b may be less than or equal to 20%. Further, the deviation precision of the power supply voltage Vcc_b may be less than or equal to 10%. Still further, the deviation precision of the power supply voltage may be less than or equal to 5%.

In still another possible implementation, as shown in D in FIG. 17, the power supply 25 is configured to supply power to the entire optoelectrical assembly, and the power supply 25 may have at least two voltage output ends, to provide a power supply voltage Vcc_c to the temperature control drive circuit 41 and the controller 24, and provide a power supply voltage Vcc_a to the voltage conversion circuit 21. The power supply voltage Vcc_a and the power supply voltage Vcc_c may be the same or different, and a value of the power supply voltage may be determined based on a current characteristic or a voltage characteristic of a device coupled to the power supply 25. In addition, the power supply voltage Vcc_c may also be used to supply power to other devices such as an ADC and a DAC.

The power supply voltage Vcc_a may range from 1.8 V to 18 V For example, the power supply voltage Vcc_a may be 3.3 V, 5 V, 12 V, or the like. Deviation precision of the power supply voltage Vcc_a may be less than or equal to 20%. Further, the deviation precision of the power supply voltage Vcc_a may be less than or equal to 10%. Still further, the deviation precision of the power supply voltage may be less than or equal to 5%.

The power supply voltage Vcc_c may range from 1.5 V to 6 V For example, the power supply voltage Vcc_c may range from 1.8 V to 3.6 V Further, the power supply voltage Vcc_c may be 3.3 V Deviation precision of the power supply voltage Vcc_c may be less than or equal to 20%. Further, the deviation precision of the power supply voltage Vcc_c may be less than or equal to 10%. Still further, the deviation precision of the power supply voltage may be less than or equal to 5%.

In various coupling manners between the power supply 25, the voltage conversion circuit 21, the temperature control drive circuit 41, and the controller 24, the power supply voltage provided by the power supply 25 is determined based on a load characteristic of a device coupled to the power supply 25. This can improve power supply energy efficiency, reduce power consumption, and improve system stability.

In addition, the voltage conversion circuit 21 may further have an enable end. When an enable signal is input from the enable end, the voltage conversion circuit 21 is enabled (enabled), and the voltage conversion circuit 21 outputs a bias voltage to the optoelectrical semiconductor device 22, to drive the optoelectrical semiconductor device 22 to emit light or amplify light from the light source. When a disable signal is input from the enable end, the voltage conversion circuit 21 is disabled (disabled), and the voltage conversion circuit 21 does not output a bias voltage to the optoelectrical semiconductor device 22, and the optoelectrical semiconductor device 22 does not emit light or cannot amplify light from the light source. It should be noted that the enable signal and the disable signal may be signals of different levels.

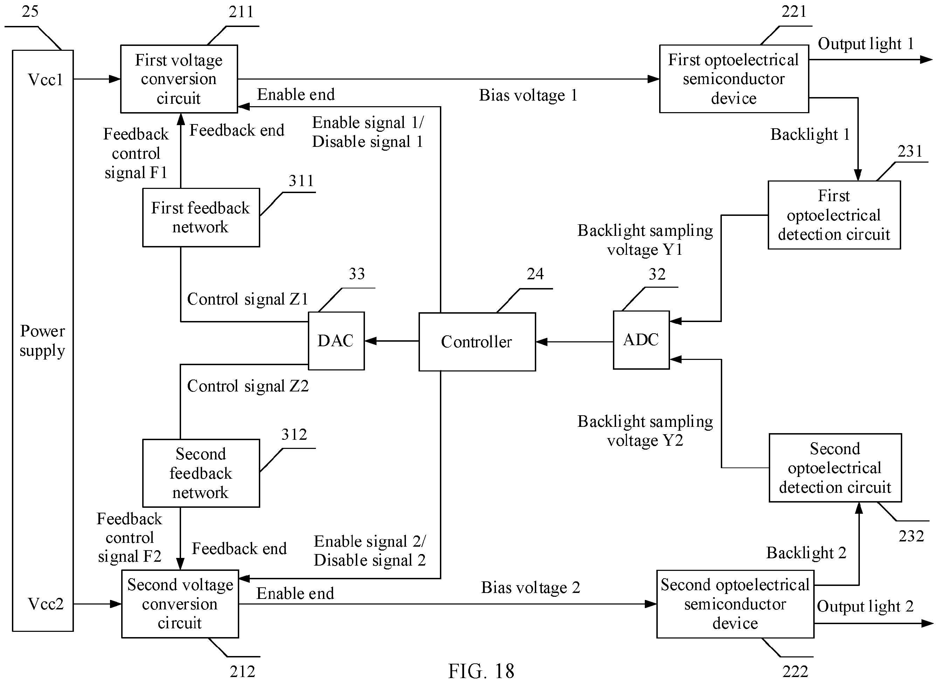

For example, as shown in FIG. 18, based on FIG. 10, the first voltage conversion circuit 211 and the second voltage conversion circuit 212 each may further have an enable end, and enable ends of all voltage conversion circuits 21 may be independently controlled by different pins of the controller 24, or may be controlled by a same pin of the controller 24 in a unified manner. When enable ends of all voltage conversion circuits 21 are independently controlled by different pins of the controller 24, the controller 24 can enable or disable at least one of the first voltage conversion circuit 211 and the second voltage conversion circuit 212, that is, independent control on different load links can be implemented, so that all optoelectrical semiconductor devices 22 are independently turned on or off. When enable ends of a plurality of voltage conversion circuits 21 are controlled by a same pin of the controller 24 in a unified manner, the plurality of optoelectrical semiconductor devices 22 can be turned on or off together. This saves pin resources of the controller 24.

When the entire optoelectrical assembly is initialized, the controller 24 outputs a disable signal to disable all voltage conversion circuits 21 (at least one of the first voltage conversion circuit 211 and the second voltage conversion circuit 212). After outputting a preset control signal, the controller 24 outputs the enable signal to enable all voltage conversion circuits 21. Alternatively, in an initialization process of the controller 24, the disable signal can be input from the enable end of the voltage conversion circuit 21 based on a fixed high/low level as an input or through another logic gate circuit, so that the voltage conversion circuit 21 is disabled in the initialization process of the controller 24. Alternatively, the enable end of the voltage conversion circuit 21 may be coupled to a soft-start circuit. In an initialization process of the controller 24, after the soft-start circuit is powered on for soft-startup, the soft-start circuit outputs an enable signal to enable the voltage conversion circuit 21, thereby turning on the optoelectrical semiconductor device 22. This can avoid an excessively large bias voltage output by the voltage conversion circuit 21 due to an unstable control signal Z in the initialization process. Otherwise, if the voltage conversion circuit 21 is in an enabled state before the controller 24 outputs the control signal Z, the bias voltage output by the voltage conversion circuit 21 is not controlled, and therefore may be excessively large. As a result, the optoelectrical semiconductor device 22 in the load link is burnt. In addition, these methods can be combined.

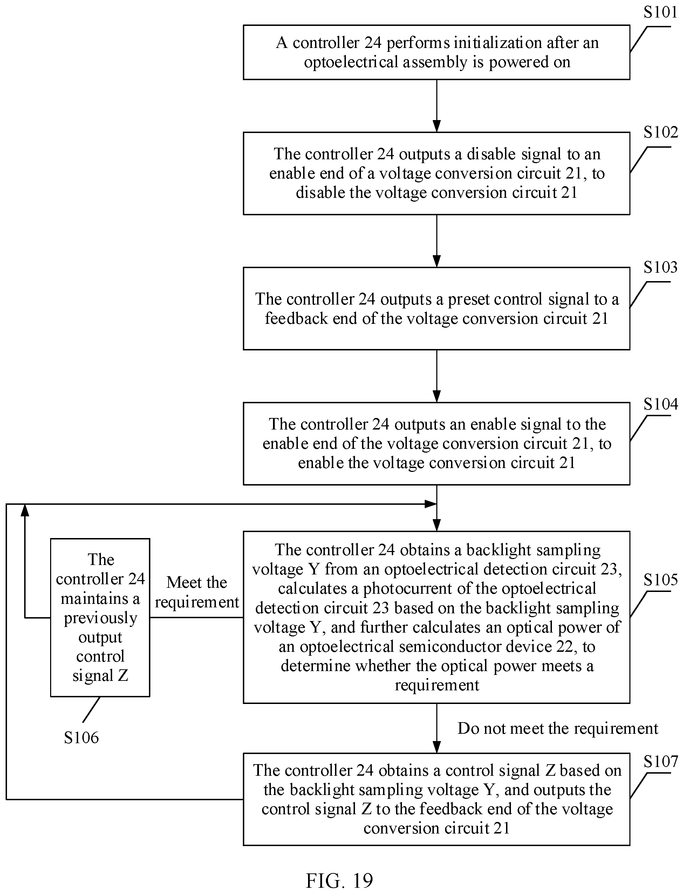

As shown in FIG. 19, for a case in which the optoelectrical assembly shown in FIG. 3 includes one voltage conversion circuit 21, for example, for a case in which the controller 24 performs enabling control to turn on or off the voltage conversion circuit 21, the controller 24 may perform the following control method for the optoelectrical assembly.

S101: The controller 24 performs initialization after the optoelectrical assembly is powered on.

S102: The controller 24 outputs a disable signal to an enable end of the voltage conversion circuit 21, to disable the voltage conversion circuit 21.

S103: The controller 24 outputs a preset control signal to a feedback end of the voltage conversion circuit 21.

The preset control signal may control the voltage conversion circuit 21 to output a default bias voltage to the optoelectrical semiconductor device 22. The DAC 33 may perform digital-to-analog conversion on the preset control signal, and the feedback network 31 may increase or decrease the preset control signal.

S104: The controller 24 outputs an enable signal to the enable end of the voltage conversion circuit 21, to enable the voltage conversion circuit 21.

The optoelectrical semiconductor device 22 emits light or amplifies light from a light source, and the optoelectrical detection circuit 23 outputs a backlight sampling voltage Y.

S105: The controller 24 obtains the backlight sampling voltage Y from the optoelectrical detection circuit 23, calculates a photocurrent of the optoelectrical detection circuit 23 based on the backlight sampling voltage Y, and further calculates an optical power of the optoelectrical semiconductor device 22, to determine whether the optical power meets a requirement.

If the requirement is met, the step S105 is performed again after step S106 is performed, or if the requirement is not met, the step S105 is performed again after step S107 is performed, to implement dynamic real-time APC.

S106: The controller 24 maintains a previously output control signal Z.

In this step, the bias voltage output by the voltage conversion circuit 21 is stabilized within a specific range, and further, the output optical power output by the optoelectrical semiconductor device 22 is stabilized within a specific range.

S107: The controller 24 obtains a control signal Z based on the backlight sampling voltage Y, and outputs the control signal Z to the feedback end of the voltage conversion circuit 21.

In this step, the bias voltage output by the voltage conversion circuit 21 changes, to change the output optical power output by the optoelectrical semiconductor device 22.

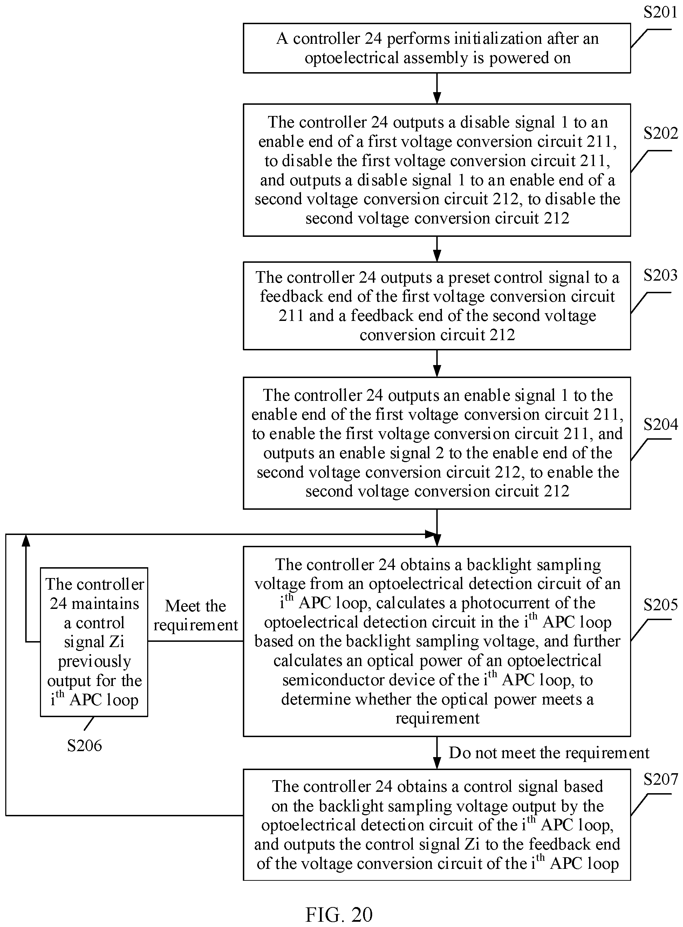

As shown in FIG. 20, for a case in which the optoelectrical assembly shown in FIG. 18 includes a plurality of voltage conversion circuits 21, the controller 24 may perform the following control method for the optoelectrical assembly.

S201: The controller 24 performs initialization after the optoelectrical assembly is powered on.

S202: The controller 24 outputs a disable signal 1 to an enable end of the first voltage conversion circuit 211, to disable the first voltage conversion circuit 211, and outputs a disable signal 1 to an enable end of the second voltage conversion circuit 212, to disable the second voltage conversion circuit 212.

S203: The controller 24 outputs a preset control signal to a feedback end of the first voltage conversion circuit 211 and a feedback end of the second voltage conversion circuit 212.

The preset control signal output by the controller 24 to the feedback end of the first voltage conversion circuit 211 may control the first voltage conversion circuit 211 to output a preset bias voltage to the first optoelectrical semiconductor device 221. The preset control signal output by the controller 24 to the feedback end of the second voltage conversion circuit 212 may control the second voltage conversion circuit 212 to output a preset bias voltage to the second optoelectrical semiconductor device 222. The two preset control signals may be the same or different. The two preset control signals may be sent to the DAC 33 in a specific sequence, and the DAC 33 performs digital-to-analog conversion on the two preset control signals; or the two preset control signals may be respectively increased or decreased by the first feedback network 311 and the second feedback network 312.

S204: The controller 24 outputs an enable signal 1 to the enable end of the first voltage conversion circuit 211, to enable the first voltage conversion circuit 211, and outputs an enable signal 2 to the enable end of the second voltage conversion circuit 212, to enable the second voltage conversion circuit 212.

The first optoelectrical semiconductor device 221 emits light or amplifies light from a light source, and the first optoelectrical detection circuit 231 outputs a backlight sampling voltage Y1. The second optoelectrical semiconductor device 222 emits light or amplifies light from a light source, and the second optoelectrical detection circuit 232 outputs a backlight sampling voltage Y2. The ADC 32 may perform analog-to-digital conversion on the backlight sampling voltage Y1 and the backlight sampling voltage Y2, and then signals obtained through analog-to-digital conversion are output to the controller 24 in a specific sequence.

S205: The controller 24 obtains a backlight sampling voltage from an optoelectrical detection circuit in an $i^{th}$ APC loop, calculates a photocurrent of the optoelectrical detection circuit in the $i^{th}$ APC loop based on the backlight sampling voltage, and further calculates an optical power of the optoelectrical semiconductor device in the $i^{th}$ APC loop, to determine whether the optical power meets a requirement.

For example, the optoelectrical assembly shown in FIG. 18 includes two APC loops, and a value of i may be 1 or 2. For a first APC loop, the controller 24 obtains the backlight sampling voltage Y1 from the first optoelectrical detection circuit 231, calculates a photocurrent of the first optoelectrical detection circuit 231 based on the backlight sampling voltage Y1, and further calculates an optical power of the first optoelectrical semiconductor device 221, to determine whether the optical power meets a requirement. For a second APC loop, the controller 24 obtains the backlight sampling voltage Y2 from the second optoelectrical detection circuit 232, calculates a photocurrent of the second optoelectrical detection circuit 232 based on the backlight sampling voltage Y2, and further calculates an optical power of the second optoelectrical semiconductor device 222, to determine whether the optical power meets a requirement.

If the requirement is met, the step S205 is performed again after step 5206 is performed, or if the requirement is not met, the step S205 is performed again after step 5207 is performed, to implement dynamic real-time APC for the $i^{th}$ APC loop.

It should be noted that, if an output optical power output by one APC loop meets the requirement, but an output optical power output by another APC loop does not meet the requirement, the controller 24 may set a software delay, and the two APC loops enter the step S205 again at the same time after different step procedures, to simplify a program control algorithm design and implement synchronization of different APC loops.

Alternatively, the controller 24 may synchronize the two APC loops when outputting control signals Z of different APC loops to the DAC 33, and the controller 24 converts the two parallel control signals Z into a serial signal according to a specific rule, and outputs the serial signal to the DAC 33. The DAC 33 decomposes and converts the serial digital signals into two analog signals according to a corresponding rule, and separately outputs the two analog signals to the feedback ends of the first feedback network 311 and the second feedback network 312.

S206: The controller 24 maintains a control signal Zi previously output for the $i^{th}$ APC loop.

In this step, the bias voltage output by the voltage conversion circuit 21 of the $i^{th}$ APC loop is stabilized within a specific range, and further, the output optical power output by the optoelectrical semiconductor device 22 of the $i^{th}$ APC loop is stabilized within a specific range.

S207: The controller 24 obtains a control signal based on the backlight sampling voltage output by the optoelectrical detection circuit of the $i^{th}$ APC loop, and outputs the control signal Zi to the feedback end of the voltage conversion circuit of the $i^{th}$ APC loop.

In this step, the bias voltage output by the voltage conversion circuit 21 of the $i^{th}$ APC loop changes, to change the output optical power output by the optoelectrical semiconductor device 22 of the $i^{th}$ APC loop.

For example, for the first APC loop, the controller 24 obtains a control signal Z1 based on the backlight sampling voltage Y1, and outputs the control signal Z1 to the feedback end of the first voltage conversion circuit 211. For the second APC loop, the controller 24 obtains a control signal Z2 based on the backlight sampling voltage Y2, and outputs the control signal Z2 to the feedback end of the second voltage conversion circuit 212.

The control method can be extended to a scenario with a plurality of APC loops. This can implement independent control for each APC loop.

According to the control method for the optoelectrical assembly provided in embodiments of this application, when the controller is initialized, the voltage conversion circuit is first disabled, and then the voltage conversion circuit is enabled after the controller outputs the control signal to the voltage conversion circuit. Alternatively, in a controller initialization process, the voltage conversion circuit may be disabled based on a fixed high/low level as an input or through another logic gate circuit. Alternatively, in a controller initialization process, the voltage conversion circuit may be enabled through a soft-start circuit, to turn on the optoelectrical semiconductor device. In this way, the optoelectrical semiconductor device can be prevented from being burnt due to an unstable control signal in the initialization process and an excessively large bias voltage output by the voltage conversion circuit.

It should be understood that sequence numbers of the foregoing processes do not mean execution sequences in embodiments of this application. The execution sequences of the processes should be determined based on functions and internal logic of the processes, and should not constitute any limitation on implementation processes of embodiments of this application.

A person of ordinary skill in the art may be aware that, in combination with the examples described in embodiments disclosed in this specification, modules and algorithm steps may be implemented by electronic hardware or a combination of computer software and electronic hardware. Whether the functions are performed by hardware or software depends on particular applications and design constraints of technical solutions. A person skilled in the art may use different methods to implement the described functions for each particular application, but it should not be considered that this implementation goes beyond the scope of this application.

It may be clearly understood by a person skilled in the art that, for the purpose of convenient and brief description, for a detailed operating process of the foregoing system, apparatus, and module, refer to a corresponding process in the foregoing method embodiments, and details are not described herein again.

In the several embodiments provided in this application, it should be understood that the disclosed system, device, and method may be implemented in another manner. For example, the described device embodiment is merely an example. For example, division into the modules is merely logical function division and may be other division during actual implementation. For example, a plurality of modules or components may be combined or integrated in another device, or some features may be ignored or not performed. In addition, the displayed or discussed mutual couplings or direct couplings or communication connections may be implemented through some interfaces. The indirect couplings or communication connections between the devices or modules may be implemented in electrical, mechanical, or other forms.

The modules described as separate parts may or may not be physically separate, parts displayed as modules may or may not be physical modules, may be located in one device, or may be distributed on a plurality of devices. Some or all of the modules may be selected based on an actual requirement to achieve the objectives of the solutions of the embodiments.

In addition, functional modules in embodiments of this application may be integrated into one device, or each of the modules may exist alone physically, or two or more modules may be integrated into one device.

All or some of the foregoing embodiments may be implemented by software, hardware, firmware, or any combination thereof. When a software program is used to implement embodiments, all or some of embodiments may be implemented in a form of a computer program product. The computer program product includes one or more computer instructions. When the computer program instructions are loaded and executed on a computer, the procedures or functions according to embodiments of this application are all or partially generated. The computer may be a general-purpose computer, a dedicated computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (Digital Subscriber Line, DSL)) or wireless (for example, infrared, radio, or microwave) manner. The computer-readable storage medium may be any usable medium accessible by a computer, or a data storage device, such as a server or a data center, integrating one or more usable media. The usable medium may be a magnetic medium (for example, a floppy disk, a hard disk drive, or a magnetic tape), an optical medium (for example, a DVD), a semiconductor medium (for example, a solid-state drive (Solid State Disk, SSD)), or the like.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

**Claims**

1. An optoelectrical assembly, comprising a voltage conversion circuit, an optoelectrical semiconductor device, an optoelectrical detection circuit, and a controller, wherein

   the voltage conversion circuit is configured to: provide a bias voltage to the optoelectrical semiconductor device, and adjust, by changing the bias voltage, an output optical power output by the optoelectrical semiconductor device, wherein a differential resistance value Rdiff of the optoelectrical semiconductor device within a range of a target optical power satisfies 0.1 $\Omega \le$ Rdiff$\le$50 Q, and the differential resistance value is a ratio of a voltage variation to a current variation corresponding to the voltage variation;
   the optoelectrical detection circuit is configured to: detect the output optical power output by the optoelectrical semiconductor device, and output a detection signal to the controller; and
   the controller is configured to: determine a control signal based on the detection signal, and output the control signal to the voltage conversion circuit, wherein the control signal is used to adjust the bias voltage.

2. The optoelectrical assembly according to claim 1, wherein a differential resistance Rdiffsub of the optoelectrical semiconductor device within a sub-range of the target optical power and an average differential resistance Rdiffavg within the range of the target optical power satisfy: max(0.02*Rdiffavg, 0.1 $\Omega$)$\le$Rdiffsub$\le$min(50*Rdiffavg, 50 S2);

   max(0.02*Rdiffavg, 0.1 S2) indicates a larger value of 0.02*Rdiffavg and 0.1 Q, and min(50*Rdiffavg, 50 S2) indicates a smaller value of 50*Rdiffavg and 50 Q; and
   the average differential resistance Rdiffavg indicates a ratio of a bias voltage variation corresponding to a lower optical power limit and an upper optical power limit of the optoelectrical semiconductor device within the range of the target optical power to a corresponding current variation.

3. The optoelectrical assembly according to claim 1 or 2, wherein the optoelectrical semiconductor device is a light source, and a resistance value of the light source is less than or equal to 60 Q within the range of the target optical power.

4. The optoelectrical assembly according to claim 1 or 2, wherein the optoelectrical semiconductor device is an optical amplifier, and a resistance value of the optical amplifier is less than or equal to 60 Q within the range of the target optical power.

5. The optoelectrical assembly according to claim 3 or 4, wherein the voltage conversion circuit is a unique bias adjustment circuit of the optoelectrical semiconductor device.

6. The optoelectrical assembly according to any one of claims 1 to 5, wherein a bit width of a digital signal processed by the controller is greater than or equal to 6 bits.

7. The optoelectrical assembly according to any one of claims 1 to 6, wherein the controller is further configured to: enable or disable the voltage conversion circuit.

8. The optoelectrical assembly according to any one of claims 1 to 7, wherein the controller is configured to: obtain load link information, and determine the control signal based on the load link information and the detection signal, wherein the load link information comprises a value of the bias voltage.

9. The optoelectrical assembly according to any one of claims 1 to 8, wherein the optoelectrical assembly further comprises a temperature control drive circuit and a temperature control circuit, the temperature control drive circuit is configured to supply power to the temperature control circuit, and the temperature control circuit is configured to perform temperature control on the optoelectrical semiconductor device.

10. The optoelectrical assembly according to claim 9, wherein a power supply voltage input by the temperature control drive circuit ranges from 2 V to 18 V

11. The optoelectrical assembly according to any one of claims 1 to 10, wherein a power supply voltage input by the voltage conversion circuit ranges from 1.8 V to 18 V

12. The optoelectrical assembly according to any one of claims 1 to 11, wherein a power supply voltage input by the controller ranges from 1.5 V to 6 V

13. The optoelectrical assembly according to any one of claims 1 to 12, wherein a voltage ripple obtained by performing filtering on the bias voltage output by the voltage conversion circuit is less than or equal to 50 mV.

14. The optoelectrical assembly according to any one of claims 1 to 13, wherein the voltage conversion circuit comprises a first voltage conversion circuit and a second voltage conversion circuit, the optoelectrical semiconductor device comprises a first optoelectrical semiconductor device and a second optoelectrical semiconductor device, and the optoelectrical detection circuit comprises a first optoelectrical detection circuit and a second optoelectrical detection circuit, wherein

the first optoelectrical detection circuit is configured to: detect an output optical power output by the first optoelectrical semiconductor device, and output a first detection signal to the controller;
the second optoelectrical detection circuit is configured to: detect an output optical power output by the second optoelectrical semiconductor device, and output a second detection signal to the controller; and
the controller is configured to: determine a first control signal based on the first detection signal, and send the first control signal to the first voltage conversion circuit, wherein the first control signal is used to adjust a bias voltage provided to the first optoelectrical semiconductor device; and determine a second control signal based on the second detection signal, and send the second control signal to the second voltage conversion circuit, wherein the second control signal is used to adjust a bias voltage provided to the second optoelectrical semiconductor device.

15. The optoelectrical assembly according to claim 14, wherein the optoelectrical assembly further comprises a digital-to-analog converter;

the controller is configured to send the first control signal and the second control signal to the digital-to-analog converter in a serial manner; and
the digital-to-analog converter is configured to: perform digital-to-analog conversion on the first control signal and output a signal obtained through digital-to-analog conversion to the first voltage conversion circuit; and perform digital-to-analog conversion on the second control signal and output a signal obtained through digital-to-analog conversion to the second voltage conversion circuit.

16. The optoelectrical assembly according to claim 15, wherein a bit width of the digital-to-analog converter is greater than or equal to 6 bits.

17. The optoelectrical assembly according to any one of claims 1 to 13, wherein the optoelectrical semiconductor device comprises a first optoelectrical semiconductor device and a second optoelectrical semiconductor device, and the optoelectrical detection circuit comprises a first optoelectrical detection circuit and a second optoelectrical detection circuit;

the first optoelectrical detection circuit is configured to: detect an output optical power output by the first optoelectrical semiconductor device, and output a first detection signal to the controller;
the second optoelectrical detection circuit is configured to: detect an output optical power output by the second optoelectrical semiconductor device, and output a second detection signal to the controller; and
the controller is configured to: determine the control signal based on the first detection signal and the second detection signal, and send the control signal to the voltage conversion circuit, wherein the control signal is used to adjust a bias voltage provided to the first optoelectrical semiconductor device and a bias voltage provided to the second optoelectrical semiconductor device.

18. The optoelectrical assembly according to any one of claims 14 to 17, wherein the optoelectrical assembly further comprises an analog-to-digital converter, and the analog-to-digital converter is configured to: perform analog-to-digital conversion on the first detection signal, perform analog-to-digital conversion on the second detection signal, and output the first detection signal and the first detection signal that are obtained through analog-to-digital conversion to the controller in a serial manner.

19. The optoelectrical assembly according to claim 18, wherein a bit width of the analog-to-digital converter is greater than or equal to 6 bits.

20. The optoelectrical assembly according to any one of claims 1 to 19, wherein the optoelectrical assembly further comprises a feedback network, and the feedback network is configured to increase or decrease a voltage range of the control signal.

21. The optoelectrical assembly according to claim 20, wherein the feedback network comprises a first resistor, a second resistor, and a third resistor, wherein a second end of the first resistor is grounded, a first end of the first resistor, a second end of the second resistor, and a first end of the third resistor are coupled to a feedback end of the voltage conversion circuit, a first end of the second resistor is coupled to an output end of the voltage conversion circuit, and a second end of the third resistor is coupled to an output end of the controller; and
the output end of the controller is configured to output the control signal, and the feedback end of the voltage conversion circuit is configured to input the control signal whose voltage range is increased or decreased.

22. The optoelectrical assembly according to any one of claims 1 to 21, wherein the voltage conversion circuit is a direct current-direct current conversion circuit.

23. The optoelectrical assembly according to any one of claims 1 to 22, wherein the optoelectrical assembly is a light source or an optical amplifier separated from an optical modulator.

24. A light source pool, comprising at least one optoelectrical assembly according to any one of claims 1 to 23.

25. An optoelectrical switching device, comprising at least one of the optoelectrical assembly according to any one of claims 1 to 23 or the light source pool according to claim 24, an optical modulator, and a switching chip, wherein the optoelectrical assembly or the light source pool is configured to output light; and the switching chip is configured to control the optical modulator to modulate the light.

26. The optoelectrical switching device according to claim 25, wherein the optoelectrical switching device comprises a first controller, and the first controller is configured to: output a signal to a controller in the optoelectrical assembly to adjust an output optical power output by the optoelectrical assembly, or output a signal to a controller in the light source pool to adjust an output optical power output by the light source pool.

27. A control method for an optoelectrical assembly, applied to the optoelectrical assembly according to any one of claims 1 to 23, wherein the method comprises:

receiving a detection signal from an optoelectrical detection circuit in the optoelectrical assembly, wherein the detection signal indicates an output optical power output by an optoelectrical semiconductor device in the optoelectrical assembly; and

determining a control signal based on the detection signal, and sending the control signal to a voltage conversion circuit in the optoelectrical assembly, wherein the control signal is used to adjust a bias voltage.

28. The method according to claim 27, further comprising:
disabling the voltage conversion circuit, outputting a preset control signal to the voltage conversion circuit, and enabling the voltage conversion circuit.

29. The method according to claim 27 or 28, further comprising:

obtaining load link information, wherein the load link information comprises a value of the bias voltage; and

the determining a control signal based on the detection signal comprises: determining the control signal based on the load link information and the detection signal.

30. The method according to any one of claims 27 to 29, further comprising:
sending a first control signal and a second control signal to a digital-to-analog converter in the optoelectrical assembly in a serial manner, wherein the first control signal is used to adjust a bias voltage provided to a first optoelectrical semiconductor device, and the second control signal is used to adjust a bias voltage provided to a second optoelectrical semiconductor device.

31. The method according to any one of claims 27 to 29, further comprising:
determining the control signal based on a first detection signal and a second detection signal, and sending the control signal to the voltage conversion circuit, wherein the control signal is used to adjust a bias voltage provided to a first optoelectrical semiconductor device and a bias voltage provided to a second optoelectrical semiconductor device, the first detection signal indicates an output optical power output by the first optoelectrical semiconductor device, and the second detection signal indicates an output optical power output by the second optoelectrical semiconductor device.

FIG. 1

FIG. 2

FIG. 3

FIG. 4

EP 4 340 255 A1

FIG. 5

FIG. 6

211

25

Vcc1 → First voltage
conversion circuit → Load link 1

Power
supply

212

Vcc2 → Second voltage
conversion circuit → Load link 2

FIG. 7A

211

25

Vcc1 → First voltage
conversion circuit → Load link 1

Power
supply

212

Second voltage
conversion circuit → Load link 2

FIG. 7B

FIG. 7C

FIG. 7D

221

222

Load link

First optoelectrical
semiconductor device

Second optoelectrical
semiconductor device

FIG. 7E

221

First optoelectrical
semiconductor device

Load link

222

Second optoelectrical
semiconductor device

FIG. 7F

Digital signal        Analog signal

FIG. 8A

Digital signal        Analog signal

FIG. 8B

Digital signal

Analog signal

FIG. 8C

Digital signal

Analog signal

FIG. 8D

Analog signal                    Digital signal

                    33                                24

Control signal 1
                    out1
                            DAC                    Controller

Control signal 2
                    out2

                                    Control
                                 signals 1 to 4
Control signal 3         in1                    out5
                    out3

Control signal 4
                    out4

FIG. 9A

Analog signal                    Digital signal

                    331                                24

Control signal 1                    Control
                    out1        signals 1 and 2
                            in1                    out5

Control signal 2
                    out2    First DAC

Control signal 3                    Control
                    out3        signals 3 and 4
                            in2

Control signal 4                                    out6
                    out4    Second DAC            Controller

                    332

FIG. 9B

FIG. 9C

FIG. 9D

FIG. 10

EP 4 340 255 A1

```
  25                    21                                                              22          Output light
┌─────────┐      ┌──────────────┐                                          ┌──────────────────┐
│  Power  │      │   Voltage    │              Bias voltage                │  Optoelectrical  │─────────────▶
│ supply  │─────▶│  conversion  │─────────────────────────┬───────────────▶│  semiconductor   │
│         │      │   circuit    │                          │               │      device       │
└─────────┘      └──────────────┘                          │               └──────────────────┘
                        ▲                                   │                        │
                        │                                   │                        │          Backlight
                        │                           Load link information X          │
                        │                                   │                        │
                        │                                   ▼                        ▼
                        │                          ┌──────────────┐  Backlight sampling   ┌──────────────────┐
                        │       Control signal Z   │      24      │     voltage Y         │        23        │
                        └──────────────────────────│  Controller  │◀──────────────────────│  Optoelectrical  │
                                                   │              │                       │ detection circuit │
                                                   └──────────────┘                       └──────────────────┘
```

FIG. 11

EP 4 340 255 A1

FIG. 12

FIG. 13

EP 4 340 255 A1

EP 4 340 255 A1

```
  25                    21                                                          22
┌─────────┐      ┌──────────────┐                                         ┌──────────────────┐    Output light
│  Power  │      │   Voltage    │              Bias voltage               │  Optoelectrical  │─────────────▶
│ supply  │─────▶│  conversion  │────────────────────────────────────────▶│  semiconductor   │
│         │      │   circuit    │                                         │     device       │
└─────────┘      └──────────────┘                                         └──────────────────┘
                        ▲    │                                                       │
                        │    │                                                       │
                        │    │         Load link information X                       │  Backlight
                        │    │                                                       │
                        │    └──────────────────┐                                    │
                        │                        ▼                                    ▼
                        │                  ┌──────────┐        Backlight sampling    ┌──────────────────┐
          Control signal Z                │    24    │          voltage Y            │       23         │
                        │                 ┌──────────────┐◀──────────────────────────┤  Optoelectrical  │
                        └─────────────────│  Controller  │                           │ detection circuit│
                                          └──────────────┘                           └──────────────────┘

                                          FIG. 14
```

EP 4 340 255 A1

FIG. 15

EP 4 340 255 A1

FIG. 16

FIG. 17

FIG. 18

EP 4 340 255 A1

FIG. 19

A controller 24 performs initialization after an optoelectrical assembly is powered on — S201

The controller 24 outputs a disable signal 1 to an enable end of a first voltage conversion circuit 211, to disable the first voltage conversion circuit 211, and outputs a disable signal 1 to an enable end of a second voltage conversion circuit 212, to disable the second voltage conversion circuit 212 — S202

The controller 24 outputs a preset control signal to a feedback end of the first voltage conversion circuit 211 and a feedback end of the second voltage conversion circuit 212 — S203

The controller 24 outputs an enable signal 1 to the enable end of the first voltage conversion circuit 211, to enable the first voltage conversion circuit 211, and outputs an enable signal 2 to the enable end of the second voltage conversion circuit 212, to enable the second voltage conversion circuit 212 — S204

The controller 24 maintains a control signal $Z_i$ previously output for the $i^{th}$ APC loop — S206

Meet the requirement

The controller 24 obtains a backlight sampling voltage from an optoelectrical detection circuit of an $i^{th}$ APC loop, calculates a photocurrent of the optoelectrical detection circuit in the $i^{th}$ APC loop based on the backlight sampling voltage, and further calculates an optical power of an optoelectrical semiconductor device of the $i^{th}$ APC loop, to determine whether the optical power meets a requirement — S205

Do not meet the requirement

The controller 24 obtains a control signal based on the backlight sampling voltage output by the optoelectrical detection circuit of the $i^{th}$ APC loop, and outputs the control signal $Z_i$ to the feedback end of the voltage conversion circuit of the $i^{th}$ APC loop — S207

FIG. 20

## INTERNATIONAL SEARCH REPORT

International application No.

**PCT/CN2022/097945**

### A. CLASSIFICATION OF SUBJECT MATTER

H04B 10/564(2013.01)i

According to International Patent Classification (IPC) or to both national classification and IPC

### B. FIELDS SEARCHED

Minimum documentation searched (classification system followed by classification symbols)

H04B

Documentation searched other than minimum documentation to the extent that such documents are included in the fields searched

Electronic data base consulted during the international search (name of data base and, where practicable, search terms used)

CNTXT; CNABS; WOTXT; USTXT; EPTXT; VEN; IEEE; CNKI: 自动功率控制, 微分电阻, 激光二极管, 激光器, 光功率, 直流, 转换, 变换, automatic power control, APC, differential resistance, laser diode, laser, optical power, direct current, DC, convert

### C. DOCUMENTS CONSIDERED TO BE RELEVANT

| Category* | Citation of document, with indication, where appropriate, of the relevant passages | Relevant to claim No. |
|---|---|---|
| Y | CN 111048991 A (QXP TECHNOLOGIES INC.) 21 April 2020 (2020-04-21) description, paragraphs [0003]-[0042], and figure 1 | 1-31 |
| Y | JP 2008235701 A (SUMITOMO ELECTRIC INDUSTRIES) 02 October 2008 (2008-10-02) description, paragraphs [0013]-[0014], and figure 2 | 1-31 |
| Y | CN 203193119 U (SHENZHEN XINFEI TONGGUANG ELECTRONIC TECHNOLOGY CO., LTD.) 11 September 2013 (2013-09-11) description, paragraphs [0022]-[0035], and figure 1 | 1-31 |
| A | CN 208874055 U (NANJING HUAJIE IMI TECHNOLOGY CO., LTD.) 17 May 2019 (2019-05-17) entire document | 1-31 |

☐ Further documents are listed in the continuation of Box C.  ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **03 August 2022** | **19 August 2022** |

| Name and mailing address of the ISA/CN | Authorized officer |
|---|---|
| **China National Intellectual Property Administration (ISA/CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2022/097945**

| Patent document cited in search report | | | Publication date (day/month/year) | Patent family member(s) | Publication date (day/month/year) |
|---|---|---|---|---|---|
| CN | 111048991 | A | 21 April 2020 | None | |
| JP | 2008235701 | A | 02 October 2008 | None | |
| CN | 203193119 | U | 11 September 2013 | None | |
| CN | 208874055 | U | 17 May 2019 | None | |

Form PCT/ISA/210 (patent family annex) (January 2015)

**REFERENCES CITED IN THE DESCRIPTION**

**Patent documents cited in the description**

- CN 202110657331